# EUROPEAN PATENT SPECIFICATION

(11) **EP 1 555 731 B1**
(45) Date of publication and mention of the grant of the patent: **14.04.2010**
(21) Application number: 03799114.8
(22) Date of filing: 19.09.2003
(51) Int. Cl.: H01S 5/22, H01S 5/323

(54) **SEMICONDUCTOR LASER DEVICE AND PRODUCTION METHOD THEREFOR**
HALBLEITERLASERBAUELEMENT UND DESSEN HERSTELLUNGSVERFAHREN
DISPOSITIF LASER À SEMICONDUCTEUR ET SON PROCÉDÉ DE PRODUCTION

(30) Priority: 20.09.2002 JP 2002274492
(43) Date of publication of application: 20.07.2005
(73) Proprietor: Sony Corporation, Tokyo 141-0001 (JP)
(72) Inventor: Sato, Yoshifumi, Shinagawa-ku, Tokyo 141-0001 (JP); Imanishi, Daisuke, Shinagawa-ku, Tokyo 141-0001 (JP)
(74) Representative: Delumeau, François Guy
(86) International application number: PCT/JP2003/011985
(87) International publication number: WO 2004/032296

(56) References cited:
- JP-A- 4 111 375
- JP-A- 4 177 782
- JP-A- 4 177 782
- JP-A- 8 078 775
- JP-A- 11 068 154
- JP-A- 2001 257 414
- US-A- 5 832 019
- US-A- 5 963 572
- US-A1- 2001 017 871
- US-A1- 2002 050 601
- US-B1- 6 174 747
- BO LU ET AL: "High power, high reliability single mode lasers at 640-650 nm with low aspect ratio" LASERS AND ELECTRO-OPTICS SOCIETY ANNUAL MEETING, 1997. LEOS '97 10TH ANNUAL MEETING. CONFERENCE PROCEEDINGS., IEEE SAN FRANCISCO, CA, USA 10-13 NOV. 1997, NEW YORK, NY, USA,IEEE, US, vol. 1, 10 November 1997 (1997-11-10), pages 85-86, XP010252464 ISBN: 0-7803-3895-2
- PATENT ABSTRACTS OF JAPAN vol. 2000, no. 26, 1 July 2002 (2002-07-01) -& JP 2001 257414 A (SONY CORP), 21 September 2001 (2001-09-21)
- FUJII H ET AL: "HIGH-POWER OPERATION OF A TRANSVERSE-MODE STABILISED ALGAINP VISIBLE LIGHT (LAMBDAL = 683 NM) SEMICONDUCTOR LASER" ELECTRONICS LETTERS, IEE STEVENAGE, GB, vol. 23, no. 18, 27 August 1987 (1987-08-27), pages 938-939, XP000710290 ISSN: 0013-5194
- PATENT ABSTRACTS OF JAPAN vol. 2000, no. 24, 11 May 2001 (2001-05-11) & JP 2001 185818 A (MITSUBISHI ELECTRIC CORP), 6 July 2001 (2001-07-06)
- KOBAYASHI R ET AL: "REAL INDEX GUIDED ALGAINP VISIBLE LASER WITH HIGH BANDGAP ENERGY ALINP CURRENT BLOCKING LAYER GROWN HCL-ASSISTED METALORGANIC VAPOR PHASE EPITAXY" PROCEEDINGS OF THE INTERNATIONAL SEMICONDUCTOR LASER CONFERENCE. MAUI, HAWAII, SEPT. 19 - 23, 1994, NEW YORK, IEEE, US, vol. CONF. 14, 19 September 1994 (1994-09-19), pages 243-244, XP000670644 ISBN: 0-7803-1755-6

## Description

### TECHNICAL FIELD

The present invention relates to a semiconductor laser device and its manufacturing method, and in detail relates to a high output semiconductor laser device, which is high in current confinement effect, small in leak current and favorable in temperature property, and more particular relates to a high output semiconductor laser device, which is used for a light source of an information processing apparatus such as an optical disc of a rewritable type and the like, and further, for a light source of a projector and a light source for a general usage and an industrial equipment such as a welding machine and the like, and relates to its manufacturing method.

### BACKGROUND ART

In recent years, as a light source of an information processing apparatus for an optical disc of a rewritable type such as a DVD (Digital Versatile Disc) and the like, a high output semiconductor laser of a 600-nm band constituted by laminated structure of AlGaInP-based compound semiconductors has been put to practical use.

By making the best use of the feature that the 600-nm band has a red visible wavelength, in particular, the 600-nm band high output semiconductor laser of a broad area type is going to be used for a light source of industrial equipments, position control equipments, medical equipments, a projector and the like. Also, a laser welding machine, a laser processing machine and the like, which use the high output semiconductor laser, are going to be used.

In the future, in those use application, the much higher output will be expected to be required. In order to attain the higher output, it is effective to drop a threshold current. Accordingly, the development of the semiconductor laser device which has the current confinement structure to drop the threshold current and increase a light output efficiency and further drops a leak current and indicates a favorable temperature property is desired.

Also, in the semiconductor laser device used in those use application, in order to control the spot shape of laser light, it is important to effectively confine the laser light to a stripe region.

In particular, the high output semiconductor laser of the broad area type, in which a stripe width of an active layer to guide the light is from several ten µm to several hundred µm, is used in a light source for solid laser excitation, or a light source for wavelength conversion that uses SHG crystal and the like, due to its feature. The high output semiconductor laser of the broad area type as mentioned above requires that the lights are collected by a micro lens, depending on the use application. Therefore, in order to obtain a higher light collection efficiency, the high output semiconductor laser indicating NFP (Near Field Pattern) of a top hat shape which is sharp in a lateral direction is required.

### Conventional First Semiconductor Laser Device

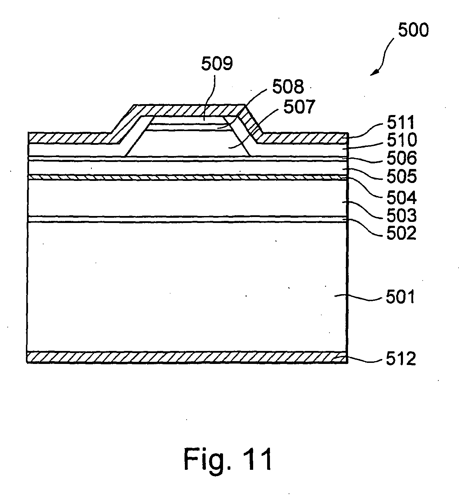

Here, with reference to Fig. 11, the configuration of the AlGaInP-based 600-nm band red semiconductor laser device of a conventional typical embedded ridge type gain guide structure is explained (hereafter, referred to as the conventional first semiconductor laser device). Fig. 11 is a sectional view showing the configuration of the conventional first semiconductor laser device.

A conventional first semiconductor laser device 500 includes the laminated structure of a buffer layer 502, an n-type clad layer 503 made of n-AlGaInP, an SCH superlattice active layer 504 made of Al_{z}Ga_{1-z}InP having at least one quantum well structure, a first p-type clad layer 505 made of p-AlGaInP, an etching stop layer 506 made of GaInP, a second p-type clad layer 507 made of p-AlGaInP, a protective layer 508 made of GaInP, and a p-GaAs contact layer 509, which are sequentially grown on an n-type GaAs substrate 501, as shown in Fig. 11.

The buffer layer 502 is a buffer layer composed of at least one of an n-GaAs layer or an n-GaInP layer.

In the laminated structure, the p-AlGaInP second clad layer 507, the GaInP protective layer 508 and the p-GaAs contact layer 509 are formed as a stripe-shaped ridge, and a current blocking layer 510 made of n-GaAs is coated on the GaInP etching stop layer 506 on ridge sides and ridge flanks, except ridge top surface.

A p-side electrode 511 is formed on the p-GaAs contact layer 509 and the n-GaAs current blocking layer 510, and an n-side electrode 512 is formed on a rear of the n-type GaAs substrate 501.

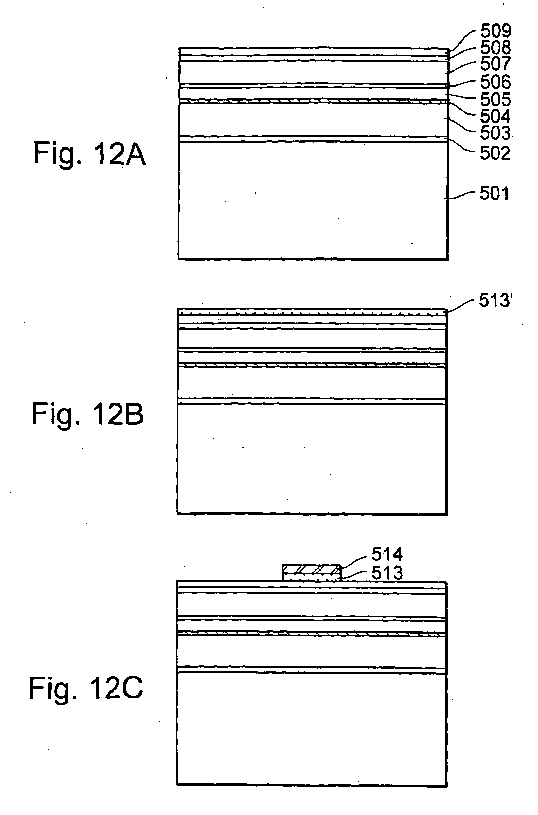

The manufacturing method of the above-mentioned conventional first semiconductor laser device 500 will be described below with reference to Figs. 12A to 12F. Figs. 12A to 12F are sectional views for each step when the conventional first semiconductor laser device 500 is manufactured in accordance with the conventional method, respectively.

At first, as shown in Fig. 12A, at a first epitaxial growth step, an metal organic vapor phased growing method, such as an MOVPE (Metal Organic Vapor Phase Epixtaxy) method, an MOCVD (Metal-Organic Chemical Vapor Deposition) method or the like, is used to epitaxially grow the buffer layer 502, the n-AlGaInP n-type clad layer 503, the GaInP superlattice active layer 504, the p-AlGaInP first p-type clad layer 505, the GaInP etching stop layer 506, the p-AlGaInP second clad layer 507, the GaInP protective layer 508 and the p-GaAs contact layer 509, sequentially on the n-GaAs substrate 501, thereby forming the lamination layer body having double hetero-structure.

In the epitaxial growth, as dopant, Si and Se are used on the n-side, and Zn, Mg, Be and the like are used on the p-side.

Next, as shown in Fig. 12B, an SiO₂ film 513' is formed on the p-GaAs contact layer 509 of the formed lamination layer body, for example, by using a plasma CVD method.

Next, as shown in Fig. 12C, a resist film is formed on the SiO₂ film 513' and patterned by photographic etching, thereby forming a stripe-shaped resist mask 514. In succession, the resist mask 514 is used as a mask, and the SiO₂ film 513' is etched, thereby forming a stripe-shaped SiO₂ film 513.

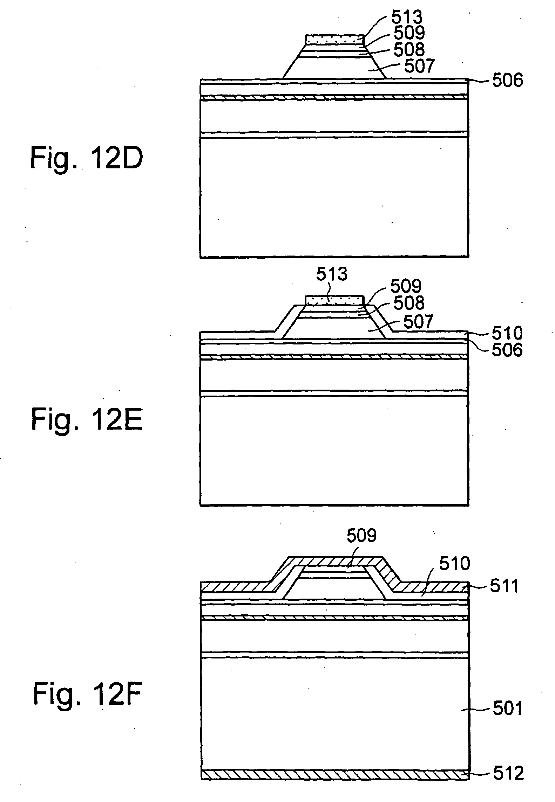

Next, as shown in Fig. 12D, this stripe-shaped SiO₂ film 513 is used as a mask, and the p-GaAs contact layer 509, the GaInP protective layer 508 and the p-AlGaInP second clad layer 507 are etched and processed into the stripe-shaped ridge.

When the p-GaAs contact layer 509 is etched, etchant that can selectively remove this, for example, phosphoric-acid-based etchant is used to carry out a wet etching. At the time of the etching, since the GaInP protective layer 508 is provided, the progress of the etching is stopped there, and since the p-AlGaInP second clad layer 507 is not exposed in air, it is not oxidized.

In succession, in etching the GaInP protective layer 508, the wet etching that uses, for example, hydrochloric-acid-based etchant is performed. At this time, if the etching is performed in a period longer than necessary, even the p-AlGaInP second clad layer 507 and the GaInP etching stop layer 506 are etched. Thus, the control of the etching period is required. When the GaInP protective layer 508 is etched, at the same time, the p-AlGaInP second clad layers 507 on both flanks of the p-GaAs contact layer 509 are etched more or less. However, it does not reach the GaInP etching stop layer 506.

Next, the p-AlGaInP second clad layer 507 left when the GaInP protective layer 508 is etched is etched, for example, by using sulfuric-acid-based etchant. The etching is stopped when the GaInP etching stop layer 506 is exposed, because the GaInP etching stop layer 506 is provided.

Next, the flow of this method proceeds to a second epitaxial growing step. At the second epitaxial growing step, as shown in Fig. 12E, the stripe-shaped SiO₂ film 513 is used as a selective growth mask, and the metal-organic vapor phased growing method such as the MOVPE method, the MOCVD method or the like is applied to epitaxially grow the n-GaAs current blocking layer 510 on the GaInP etching stop layer 506 on the slope ridge sides and ridge flanks.

Next, the stripe-shaped SiO₂ film 513 is etched and removed.

Finally, as shown in Fig. 12F, the p-side electrode 511 is formed on the p-GaAs contact layer 509 and the n-GaAs current blocking layer 510, and the rear of the n-GaAs substrate 501 is polished and adjusted to a predetermined substrate thickness. Then, the n-side electrode 512 is formed on the rear. Consequently, it is possible to obtain the semiconductor wafer for the laser, which has the laminated structure shown in Fig. 11.

Next, this semiconductor wafer for the laser is cleaved in the ridge stripe direction and the vertical direction. Consequently, it is possible to manufacture the semiconductor laser device 500 having a pair of resonator reflection surfaces.

Due to the employment of the above-mentioned ridge structure, the n-GaAs current blocking layer 510 can effectively carry out the current blocking function for the p-AlGaInP second clad layer 507, and the current injected from the p-side electrode 511 is narrowed by the n-GaAs current blocking layer 510 and flows into the active layer 504. If the current equal to or greater than a threshold current flows, an electron and a hole are efficiently re-combined, and the laser light is oscillated.

By the way, the employment of the above-mentioned current confinement structure using the n-GaAs current blocking layer 510 optically increases the light loss of the semiconductor laser device, which consequently results in a problem of the increase in the oscillation threshold current.

That is, a refractive index of the n-GaAs current blocking layer 510 is greater than refractive indexes of the p-AlGaInP first and second clad layers 505, 507. Thus, although the light is not absorbed by the ridge-shaped p-AlGaInP second clad layer 507, it is absorbed by the n-GaAs current blocking layer 510 of the ridge flanks of the p-AlGaInP second clad layer 507.

As this result, the light generated by the active layer 504 indicates the motion that it is oozed into the p-AlGaInP second clad layer 507 and pushed back as it approaches the n-GaAs current blocking layer 510. Thus, an effective refractive index becomes low in the n-GaAs current blocking layer 510 in a laterally extending region. That is, since a refractive index difference is induced in the lateral direction of the active layer 504, a refractive index light waveguide is performed.

For this reason, in the structure employing the n-GaAs current blocking layer, the light absorption occurring in the n-GaAs current blocking layer 510 brings about the light loss on the laser oscillation, which results in a problem that the threshold current is increased.

### Conventional Second Semiconductor Laser Device

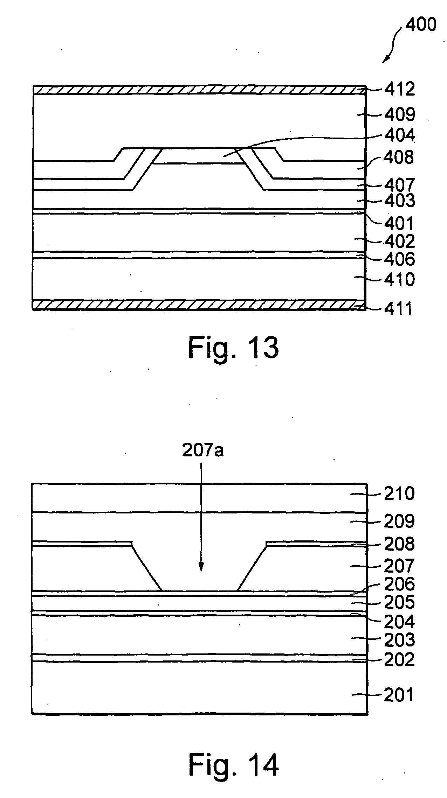

So, in order to attain a low threshold current of the semiconductor laser device, a method of using the effective refractive index light waveguide, namely, a semiconductor laser device of an effective refractive index light waveguide type (hereafter, referred to as the conventional second semiconductor laser device) in which instead of the n-GaAs current blocking layer 510 in Fig. 13, an n-AlInP layer is provided as a current blocking layer is proposed by Ryuji Kobayashi in the International Semiconductor Laser Conference (a page 243 of the proceeding, in 1994).

Here, the configuration of the conventional second semiconductor laser device is explained with reference to Fig. 13. Fig. 13 is a sectional view showing the configuration of the conventional second semiconductor laser device.

A conventional second semiconductor laser device 400 includes the laminated structure of an n-GaAs buffer layer 406, an n-AlGaInP clad layer 402, an MQW active layer 401, a p-AlGaInP clad layer 403 and a p-GaInP cap layer 404, which are sequentially grown on an n-GaAs substrate 401, as shown in Fig. 13.

In the laminated structure, the upper layers of the p-AlGaInP clad layer 403 and the p-GaInP cap layer 404 are processed into the stripe-shaped ridge. The low layer of the p-AlGaInP clad layer 403 of the ridge sides and the ridge flanks is coated with the laminated structure of an AlInP current blocking layer 407 and an n-GaAs current blocking layer 408, and further embedded with a p-GaAs contact layer 409.

A p-side electrode 412 is formed on the p-GaAs contact layer 409, and an n-side electrode 411 is formed on a rear of the n-GaAs substrate 410, respectively.

In the conventional second semiconductor laser device 400, the AlInP current blocking layer 407 formed on the p-AlGaInP clad layer 403 of the ridge sides and of the ridge flanks functions as a current blocking layer, and simultaneously functions as a lateral light confining layer by a refractive index difference from the p-AlGaInP clad layer 403.

In the semiconductor laser device 400, the AlInP is lower in the refractive index than the AlGaInP clad layer, and there is no light absorption. Thus, it is confirmed that an inner loss is small, an oscillation threshold current can be reduced, and a light output efficiency is increased.

Also, another example of employing the n-AlInP as the current blocking layer is proposed by Japanese Patent Application Publication No. 2001-185818. According to this, at a first epitaxial growth step, the p-AlGaInP clad layer 403 is not made to grow, but the n-AlInP current blocking layer 407 is made to firstly grow.

Next, the n-AlInP current blocking layer 407 is etched to form so as to have the shape of the stripe-shaped ridge, and the p-AlGaInP clad layer 403 is made to grow at a second epitaxial growing step. This method is done in this way.

### Conventional Third Semiconductor Laser Device

Also, in Japanese Patent Application Publication No. Hei-5-299767, a semiconductor laser device that employs n-AlInP as the current blocking layer is proposed. (hereafter, referred to as a conventional third semiconductor laser device) as shown in Fig. 14.

This semiconductor laser device 200 includes the laminated structure of an n-GaAs buffer layer 202, an n-AlGaInP clad layer 203, a GaInP active layer 204, a p-AlGaInP first optical guide layer 205, a p-GaInP second optical guide layer 206, an n-AlInP current blocking layer 207 and a GaInP protective layer 208, which are sequentially grown on an n-GaAs substrate 201, as shown in Fig. 14.

In the laminated structure, an inverted trapezoidal groove 207a is formed in the GaInP protective layer 208 and the n-AlInP current blocking layer 207 by means of etching process, and embedded with a p-AlGaInP clad layer 209. Then, a p-GaAs contact layer 210 is laminated on a p-AlGaInP clad layer 209.

In the conventional third semiconductor laser device 200, since a refractive index of the n-AlInP current blocking layer 207 is smaller than a refractive index of the p-AlGaInP clad layer 209 inside the stripe, the laser light is effectively confined inside the stripe due to this refractive index difference.

Moreover, since a band gap of the n-AlInP current blocking layer 207 is considerably larger than a band gap of the active layer 204, there is no light absorption of the laser light caused by the current blocking layer. Thus, the loss of a light waveguide can be largely reduced, thereby dropping the threshold current.

Also, according to the above-mentioned gazette, it is described that in the semiconductor laser device 200, since an Al composition of the n-AlInP current blocking layer 207 is set to be higher than an Al composition of the p-AlGaInP clad layer 209 (AlInP in the maximum condition), an actual refractive index wave guide structure can be attained, thereby reducing the loss of the waveguide largely.

However, the conventional high output semiconductor laser devices including the above-mentioned conventional second and third semiconductor laser devices have the following problems.

### Problem of Conventional Second Semiconductor Laser Device

A first problem of the conventional second semiconductor laser device 400 is that when the metal- organic vapor phased growing method, such as the MOVPE method, the MOCVD method and the like, is used to re-grow the AlInP current blocking layer on the ridge sides and the ridge flanks since a grid constant of the AlInP is greatly different between a flat portion of the ridge flanks and a slant portion of the ridge sides, a crystal distortion is induced in the AlInP current blocking layer. For this reason, adverse affect is induced in laser property and reliability.

The occurrence of the crystal distortion at the time of the re-growth is because at the time of the metal-organic vapor phased growth of the AlInP current blocking layer, the fact that the grid constant of the AlInP is greatly different between the flat portion of the ridge flanks and the slant portion of the ridge sides causes the crystal planes of two kinds or more, which are different from each other, to be formed on the growth surface, thereby bringing about the segregation of raw material kind. On the crystal planes of two kinds or more which are different from each other, diffusion coefficients of Al and In are respectively different from each other between the crystal planes, and the easiness degree when the Al and the In are taken into the crystal is different between the crystal planes, which results in the segregation of the raw material kind.

For this reason, the conventional second semiconductor laser device 400, in which as the current blocking layer, the n-AlInP layer is provided on the ridge sides and the ridge flanks, is considered to be unsuitable for the use application requiring the strict operation property, such as a high temperature operation property to a short wavelength laser device, or a high temperature high output property to a high output laser device or the like.

A second problem of the conventional second semiconductor laser device is that since a thermal conductivity of the AlInP provided as the current blocking layer is inferior to the GaAs, the heat generated from the current which can not be converted into the light in the active layer can not be efficiently released, and therefore the temperature property of the semiconductor laser device is consequently poor.

As an advantage, since the conventional second semiconductor laser device employs, as the current blocking layer, the n-AlInP whose refractive index is smaller than the p-AlGaInP first and second clad layers, the light absorption in the p-AlGaInP first clad layer is reduced, and the wave guide path loss is reduced, which enables the attainment of the low threshold current and the high optical power efficiency. This is caused by the fact that the Al composition of the n-AlInP current blocking layer is higher than the p-AlGaInP clad layer.

The AlGaInP-based material exhibits the lower refractive index as the Al composition becomes higher. Thus, if the AlGaInP-based material having the Al composition higher than the p-AlGaInP clad layer is used instead of the AlInP as the current blocking layer, the same effect can be expected.

### Problem of Conventional Third Semiconductor Laser Device

Since the conventional third semiconductor laser device 200 has the laser structure in which the stripe-shaped groove is formed in the n-AlInP current blocking layer 207 and the groove is embedded with the clad layer, it has the problem of difficulty to obtain the expected laser property because of the problem on the process when the n-AlInP current blocking layer 207 is etched to form the groove.

That is, in manufacturing the conventional third semiconductor laser device 200, after the stripe-shaped groove is opened in the n-AlInP current blocking layer 207, the re-growth of the clad layer 209 is performed. However, the current blocking layer 207 is the crystal layer having the high Al composition. Thus, if it is exposed to air by etching, the crystal surface is immediately oxidized. As this result, it is difficult to re-grow the clad layer 209 crystal that is favorable in crystal property. Incidentally, in the semiconductor laser device 200, the film thickness of the current blocking layer exposed to the air becomes 0.4 µm or more on one side.

As this result, when the semiconductor laser device 200 is operated, a large number of interface states are induced on the boundary plane between the clad layer 209 and the current blocking layer 207 whose surface is oxidized. Because of that interface state, there may be a fear that a leak current is generated.

Also, in the manufacturing process for the semiconductor laser device 200, when the stripe-shaped groove is opened in the n-AlInP current blocking layer 207, etchant such as concentrated sulfuric acid and the like is used in order to selectively etch the current blocking layer having the high Al composition.

However, if a selection ratio is set to be excessively high, it takes a long time to etch the GaInP protective layer 208. On the contrary, if the selection ratio is set to be low, there is a problem that the GaInP second light guiding layer 206 is etched. For this reason, the setting of the etching condition to reserve the selectivity is difficult, which consequently makes the control of the etching amount difficult, which causes the variation to be induced on the process.

Apart from the conventional first to third semiconductor laser devices, in Japanese Patent Application publication No. Hei-5-21896, it proposes the fact that it is effective to employ as the clad layer the AlInP possibly having the greatest barrier difference in order to reduce the threshold current, and the execution of impurity doping by using a gas source MBE method, as the solving means of the fact that it is difficult to perform a high concentration doping on the AlGaInP-based compound semiconductor layer having the great Al composition ratio such as the AlInP and the like.

However, the above-mentioned gazette illustrates only the doping means, and indicates only the method of using SiO₂ insulation film with regard to the current confinement action, and does not discuss the refractive index waveguide. However, in this structure, it is difficult to sufficiently carry out the light confining control of a lateral mode, and it is impossible to attain the refractive index waveguide.

As can be understood from the explanation of the above-mentioned subjects, if the refractive index waveguide is made to be attained by employing the AlGaInP layer having the high Al composition as the clad layer, it is desired to employ the n-AlGaInP layer having the higher Al composition ratio, for the current blocking layer.

However, if the n-AlGaInP layer having the high Al composition ratio is employed for the current blocking layer, as the Al composition of the p-AlGaInP clad layer is higher, it is more difficult to increase the refractive index difference between the p-AlGaInP clad layer and the AlGaInP current blocking layer. Thus since the effective refractive index becomes low, the light confinement becomes weak.

On the other hand, if the AlInP is employed for the p-clad layer, it is actually difficult to select the material having the Al composition higher than the AlInP as the current blocking layer, which consequently brings about a problem that there is almost no refractive index difference.

Also, even if the doping optimization to the AlGaInP having the high Al composition can be attained, the etching of the AlGaInP having the high Al composition is difficult as mentioned above, and there may be no process that can carry out the etching control for the stripe-shaped ridge formation.

In short, in the etching of the AlGaInP-based compound semiconductor layer having the high Al composition ratio such as the AlGaInP and the AlInP, an etching rate is extremely fast. Thus, when the film thickness of the clad layer is thin, the etching control is difficult as mentioned above. That is, it is difficult to control the etching depth for the sake of the etching to the shape which enables the control of the refractive index difference. Hence, the ridge formation of the favorable shape and the formation of the ridge stripe for the second epitaxial selection growth of the p-clad layer are difficult.

For example, in the gain waveguide structure of the embedded ridge type of employing the n-GaAs current blocking layer, the guiding mechanism is determined in accordance with the longitudinal distance between the current blocking layer and the active layer to generate the light. Thus, in order to obtain the efficient current confinement action and the high refractive index difference, it is necessary to sufficiently reduce the distance.

This is not limited to the gain waveguide structure of the embedded ridge type of using the n-GaAs current blocking layer. Obtaining the efficient current confinement action and the high refractive index difference requires the etching control of the AlGaInP-based compound semiconductor layer having the high Al composition ratio employed in the clad layer and the current blocking layer. However, the etching control is actually difficult.

Repeatedly explaining, in the 600 nm band red semiconductor laser having the DH (Double Hetero) structure of the embedded ridge type, the formation of the ridge structure that enables the sufficient light confinement and the efficient current confinement action is one of the most important items. To do so, the exact etching control must be carried out when the ridge is etched and processed.

Also, in the high output semiconductor laser device of the broad area type, since the stripe width becomes from several ten µm to several hundred µm, its NFP is desired to exhibit the lateral multi-mode profile of sharp top hat shape. For that purpose, the distance from the active layer to the current blocking layer needs to be the sufficiently small value.

However, in the conventional semiconductor laser device, it is difficult to sufficiently reduce the distance from the active layer to the current blocking layer. Thus, it is difficult to obtain the favorable guiding mechanism.

Also, the lateral light confinement becomes weak. Consequently, even the efficiency of the current confinement action becomes worse, the NFP profile becomes a bell-shaped Gaussian type, and a light collection efficiency is worse, which results in the inconvenient laser.

Another example of a semiconductor laser device is proposed by Bo Lu et al in the prior art document entitled "High power,High Reliability Single Mode Lasers at 640-650nm with Low Aspect Ratio" Lasers and electro-optics society annual meeting 1997 (volume 1 pages 85-86).

Yet another semiconductor laser device, disclosed in JP2001257414A, comprises: a laminated structure having AlGaInP clad layers, a ridge current confinement structure comprising a GaInP layer and a compound semiconductor layer of the ridge top surface; and an electrode made of metal film extending on a ridge top surface, ridge sides and the AlGaInP clad layer of ridge flanks, and covers the ridge top surface, the ridge sides and the AlGaInP clad layer of the ridge flanks; and a carrier concentration of the compound semiconductor layer of the ridge top surface is higher than a carrier concentration of the GaInP layer.

The present invention is made in view of the problems of the above-mentioned conventional techniques. It is therefore an object of the present invention to provide a high light output semiconductor laser apparatus, which solves the above-mentioned problems, and is high in the current confinement effect, small in the leak current, and favorable in the temperature property, and indicates the low threshold current, and can effectively confine the laser light to the stripe region, and is favorable in the beam profile and is high in the efficiency.

### Disclosure of the Invention

In order to attain the above-mentioned objects, the semiconductor laser device according to the present invention comprises the features disclosed in claim 1.

Furthermore, preferably, an AlGaInP-based compound semiconductor layer functioning as an etching stop layer extends on the second conductive type AlInP clad layer of the ridge flanks.

In an embodiment
an insulating film extends on ridge sides and the second conductive type AlInP clad layer of ridge flanks, so as to expose a ridge top surface in stripe-shaped manner, and that
the second conductive side electrode made of metal film extends on the ridge top surface exposed from the insulating film, and further on the ridge sides and the second conductive type AlInP clad layer of the ridge flanks through the insulating film.

In an embodiment
an AlGaInP-based compound semiconductor layer functioning as an etching stop layer extends on the second conductive type AlInP clad layer of the ridge flanks;
the insulating film extends on the ridge sides and the AlGaInP-based compound semiconductor layer of the ridge flanks, so as to expose the ridge top surface; and
the second conductive side electrode made of the metal film extends on the ridge top surface exposed from the insulating film, and further on the ridge sides and the AlGaInP-based compound semiconductor layer of the ridge flanks through the insulating film.

In an embodiment
an insulating film extends on the second conductive type AlInP clad layer of ridge flanks, so as to expose a ridge top surface, ridge sides and the second conductive type AlInP clad layer of ridge bottom end vicinity in stripe-shaped manner, and that
the second conductive side electrode made of metal film extends on the ridge top surface, the ridge sides and the second conductive type AlInP clad layer of the ridge bottom end vicinity, which are exposed from the insulating film, and further extends on the second conductive type AlInP clad layer of the ridge flanks through the insulating film.

In an embodiment
an AlGaInP-based compound semiconductor layer functioning as an etching stop layer extends on the second conductive type AlInP clad layer of the ridge flanks;
the insulating film extends on the AlGaInP-based compound semiconductor layer of the ridge flanks, so as to expose the ridge top surface, the ridge sides and the AlGaInP-based compound semiconductor layer of ridge bottom end vicinity; and
the second conductive side electrode made of the metal film extends on the ridge top surface, the ridge sides and the AlGaInP-based compound semiconductor layer of the ridge bottom end vicinity, which are exposed from the insulating film, and further extends on the AlGaInP-based compound semiconductor layer of the ridge flanks through the insulating film.

In an embodiment the first conductive type is an n-type, the second conductive type is a p-type, and the second conductive side electrode is a p-side electrode.

In an embodiment a stripe width of the ridge is 10 µm or more.

In an embodiment the laminated structure is a laminated structure configured by laminating: a buffer layer composed of at least one layer of an n-GaAs layer or an n-GaInP layer; an n-type clad layer made of n-AlInP; an AlGaInP-based superlattice active layer section; a first p-type clad layer made of p-AlInPan etching stop layer made of GaInP; a second p-type clad layer made of p-AlInP; a protective layer made of GaInP; and a contact layer made of p-GaAs, sequentially on an n-GaAs substrate; and
in the laminated structure, the p-AlInP second p-type clad layer and the p-GaAs contact layer are processed into the stripe-shaped ridge, thereby configuring the current confinement structure.

In an embodiment the superlattice active layer section is configured as a multiple quantum well structure composed of the quantum well layer of plural layers, which are sandwiched between the barrier layer and the optical guide layer.

A manufacturing method of a semiconductor laser device according to the present invention comprises the steps disclosed in claim 12.

In an embodiment of the manufacturing method of the semiconductor laser device the step of etching the GaInP protective layer and the p-AlInP second p-type clad layer uses a wet etching method, which used acetic acid : hydrogen peroxide : hydrochloric acid, to then etch.

In an embodiment of the manufacturing method of the semiconductor laser device the p-type compound semiconductor layer is replaced by an n-type compound semiconductor layer, and the n-type compound semiconductor layer is replaced by a p-type compound semiconductor layer, namely, they are replaced by the opposite conductive types, respectively.

In an embodiment of the manufacturing method of a semiconductor laser device it further comprises:
a step of forming an insulating film on an entire surface of the ridge top surface, the ridge sides and the GaInP etching stop layer;
a step of etching the insulating film and exposing a ridge top surface in stripe-shaped manner; and that
the metal film constituting the p-side electrode is formed on the p-GaAs contact layer of the ridge top surface and on the ridge sides and the GaInP etching stop layer of the ridge flanks through the insulating film.

In an embodiment of the manufacturing method of the semiconductor laser device
the step of etching the insulating film and exposing the ridge top surface further exposes the ridge sides and the GaInP etching stop layer of ridge bottom and vicinity; and
the step of forming the p-side electrode forms the metal film constituting the p-side electrode on the p-GaAs contact layer of the exposed ridge top surface, the ridge sides and the GaInP etching stop layer of the ridge bottom end vicinity, and further forming on the GaInP etching stop layer of the ridge flanks through the insulating film.

In an embodiment of the manufacturing method of the semiconductor laser device the step of etching the GaInP protective layer and the p-AlInP second p-type clad layer uses a wet etching method, which uses acetic acid : hydrogen peroxide : hydrochloric acid, to then etch.

In an embodiment of the manufacturing method of the semiconductor laser device the p-type compound semiconductor layer is replaced by an n-type compound semiconductor layer, and the n-type compound semiconductor layer is replaced by a p-type compound semiconductor layer, namely, they are replaced by the opposite conductive types, respectively.

In the invention, by employing the AlInP possibly having the great band gap difference from the AlGaInP-based superlattice active layer section as the clad layer and consequently increasing the barrier difference, the semiconductor laser device is attained in which the overflow of injected carriers is reduced, a leak current is small, a threshold current is low, and a temperature property is favorable.

Also, in the invention, by making the carrier concentration of the second conductive type or p-type compound semiconductor layer of the ridge top surface higher than the carrier concentration of the second conductive type or p-type AlInP clad layer, ohmic junction is formed on the ridge top surface, and Schottky junction is formed on the ridge flanks

Since this is configured such that the p-side electrode directly covers the ridge top surface, the ridge sides and the compound semiconductor layer of the ridge flanks and such that the Schottky junction is formed on the ridge flanks, the current confinement action is carried out in such a way that only the ridge region serves as the current route, and the light oozed from the active layer section is reflected by the boundary plane of the p-side electrode, thereby confining the laser light to the stripe region, and reducing the light loss.

That is, the efficient current confinement action and the effective confinement of the laser light to the stripe region can be attained, thereby achieving the semiconductor laser of the high light output efficiency. In particular, by applying the first invention to the high output semiconductor laser device of the broad area type, where the stripe width of the superlattice active layer section to which the light is guided, namely, the stripe width of the ridge is 10 µm or more, for example, the high output semiconductor laser device of 10 mW or more, it is possible to achieve the semiconductor laser device having the favorable light collection efficiency in which the lateral multi-mode profile of NFP exhibits a sharp top hat manner.

In the invention, the superlattice active layer section is constituted as an SCH (Separated Confinement Heterostructure) structure composed of at least one quantum well layer, which is sandwiched between a barrier layer and an optical guide layer, and there is a relation in which the quantum well layer is AlₓGa₁₋ₓInP (0≤1x<1), and the barrier layer is Al_{y}Ga_{1-y}InP (0<y≤1), and the Al composition is (x<y).

The superlattice active layer section may be a single quantum well structure or a multiple quantum well structure having a plurality of quantum well structures. In the single quantum well structure, the superlattice active layer section is configured as the quantum well structure composed of the quantum well layer of a single layer and the optical guide layer which puts the quantum well layer between. Also, in the multiple quantum well structure, the superlattice active layer section is configured as the quantum well structure composed of the quantum well layer of plural layers, which are sandwiched between the barrier layer and the optical guide layer.

In the concrete realization of the first embodiment, the laminated structure is a laminated structure configured by laminating: a buffer layer composed of at least one layer of an n-GaAs layer or an n-GaInP layer; an n-type clad layer made of n-AlInP; an AlGaInP-based superlattice active layer section; a first p-type clad layer made of p-AlInP; an etching stop layer made of GaInP; a second p-type clad layer made of p-AlInP; a protective layer made of GaInP; and a contact layer made of p-GaAs, sequentially on an n-GaAs substrate, and
in the laminated structure, the p-AlInP second p-type clad layer and the p-GaAs contact layer are processed into the stripe-shaped ridge.

Also, such as next second and third embodiments, insulating films of SiO₂, AlN and the like may be formed on the compound semiconductor layers of the ridge sides and the ridge flanks, and the p-side electrode may be then formed on the ridge top surface exposed from the insulating film and on the insulating films of the ridge sides and the ridge flanks. Consequently, it is possible to increase the effect of suppressing the leak current, and improve the mount control property when mounting the semiconductor laser device, and the heat radiation property and the like.

In short, another semiconductor laser device according to the present invention (hereafter, referred to as the second embodiment is characterized by including: a laminated structure sequentially having at least a first conductive type AlInP clad layer, an AlGaInP-based superlattice active layer section and a second conductive type AlInP clad layer, on a first conductive type semiconductor substrate; and a current confinement structure configured by forming an upper portion made of a second conductive type compound semiconductor layer in the laminated structure into a stripe-shaped ridge,
wherein an insulating film extends on ridge sides and the second conductive type AlInP clad layer of ridge flanks so as to expose a ridge top surface in stripe-shaped manner,
a second conductive side electrode made of metal film extends on the ridge top surface exposed from the insulating film, and further on the ridge sides and the second conductive type AlInP clad layer of the ridge flanks through the insulating film, and
a carrier concentration of the second conductive type compound semiconductor layer of the ridge top surface is higher than a carrier concentration of the second conductive type AlInP clad layer.

Moreover, still another semiconductor laser device according to the present invention (hereafter, referred to as the third embodiment) is characterized by including: a laminated structure sequentially having at least a first conductive type AlInP clad layer, an AlGaInP-based superlattice active layer section and a second conductive type AlInP clad layer, on a first conductive type semiconductor substrate; and a current confinement structure configured by forming an upper portion made of a second conductive type compound semiconductor layer in the laminated structure into a stripe-shaped ridge,
wherein an insulating film extends on the second conductive type AlInP clad layer of ridge flanks so as to expose a ridge top surface, ridge sides and the second conductive type AlInP clad layer of ridge bottom end vicinity in stripe-shaped manner,
a second conductive side electrode made of metal film extends on the ridge top surface, ridge sides and the second conductive type AlInP clad layer of the ridge bottom end vicinity, which are exposed from the insulating film, and extends further on the second conductive type AlInP clad layer of the ridge flanks through the insulating film, and
a carrier concentration of the second conductive type compound semiconductor layer of the ridge top surface is higher than a carrier concentration of the second conductive type AlInP clad layer.

In the second and third embodiments a film thickness of the insulating film is from 0.05 µm to 2.00 µm. As the insulating film, for example, SiO₂, SiN, AlN. and the like are used.

In the semiconductor laser devices according to the first to third embodiments, preferably, the stripe width of the ridge is 10 µm or more. Also, preferably, the carrier concentration of the second conductive type compound semiconductor layer of the ridge top surface is at least 10 times higher than the carrier concentration of the second conductive type AlInP clad layer.

The semiconductor laser device according to the first to third embodiments may be not a device unity and may be a semiconductor laser array or semiconductor laser stack having the structure arranged as array-shaped or stack-shaped manner.

A manufacturing method of the semiconductor laser device according to the present invention (hereafter, referred to as a first embodiment method) is a method of manufacturing the semiconductor laser device according to the first invention, and is characterized by having:
a step of sequentially epitaxial growth the buffer layer composed of at least one of the n-GaAs layer or the n-GaInP layer, the n-type clad layer made of n-AlInP, the superlattice active layer section, the first p-type clad layer made of p-AlInP, the etching stop layer made of GaInP, the second p-type clad layer made of p-AlInP, the protective layer made of GaInP, and the contact layer made of p-GaAs, on the n-GaAs substrate;
a step of etching processing the p=GaAs contact layer into the stripe-shaped manner;
a step of processing into the stripe-shaped ridge by etching the GaInP protective layer and the p-AlInP second p-type clad layer using the stripe-shaped p-GaAs contact layer as an etching mask, and exposing the GaInP etching stop layer on the ridge flanks; and
a step of forming the metal film constituting the p-side electrode on the p-GaAs contact layer of the ridge top surface, the ridge sides of the GaInP etching stop layer of the ridge flanks.

The first embodiment method has the merit that it does not require the second epitaxial growing step, because the p-side electrode is directly formed on the ridge top surface, the ridge sides and the GaInP etching stop layer of the ridge flanks without re-growing the compound semiconductor layer on the ridge flanks after the formation of the ridge.

In the preferable realization of the first embodiment method, the step of etching and processing the protective layer made of GaInP and the second p-type clad layer made of p-AlInP uses a wet etching method, which uses acetic acid : hydrogen peroxide : hydrochloric acid, to then etch.

In the laser structure of employing the AlInP clad layer, it was difficult to form the stripe-shaped ridge having the favorable shape, because the reactivity of Al was conventionally high. However, the execution of the wet etching, which uses the etchant of acetic acid : hydrogen peroxide : hydrochloric acid, enables the formation of the ridge having the favorable reproducibility and desired shape.

Also, in the first embodiment method, the hydrogen peroxide added to the etchant when the stripe-shaped ridge is formed is desired to be adjusted to the optimal amount to the degree that the effect is not reduced. If the hydrogen peroxide becomes thin, the effect as oxidant becomes thin. Also, the time to remove As remaining on the GaInP protective layer can not be controlled, which brings about the variation in an etching period, which consequently disables the process that is favorable in the reproducibility.

A manufacturing method of another semiconductor laser device according to the present invention (hereafter, referred to as a second embodiment method) is a method of manufacturing the semiconductor laser device according to the second embodiment, comprises:
a step of sequentially epitaxial growth the buffer layer composed of at least one of the n-GaAs layer or the n-GaInP layer, the n-type clad layer made of n-AlInP, the superlattice active layer section, the first p-type clad layer made of p-AlInP, the etching stop layer made of GaInP, the second p-type clad layer made of p-AlInP, the protective layer made of GaInP, and the contact layer made of p-GaAs, on the n-GaAs substrate;
a step of etching processing the p-GaAs contact layer into the stripe-shaped manner;
a step of processing into the stripe-shaped ridge by etching the GaInP protective layer and the p-AlInP second p-type clad layer using the stripe-shaped p-GaAs contact layer as the etching mask, and exposing the GaInP etching stop layer on the ridge flanks; and
a step of forming the insulating film on the entire surface of the substrate;
a step of etching the insulating film and exposing the ridge top surface in the stripe-shaped manner; and
a step of forming the metal film constituting the p-side electrode on the p-GaAs contact layer of the ridge top surface and further on the ridge sides and the GaInP etching stop layer of the ridge flanks through the insulating film.

Also, when the semiconductor laser device according to the third embodiment is manufactured, in the second embodiment method, the step of etching the insulating film and exposing ridge top surface further exposes the GaInP etching stop layer of the ridge bottom end vicinity and the ridge sides, and the step of forming the p-side electrode forms the metal film constituting the p-side electrode, on the p-GaAs contact layer of the exposed ridge top surface, the ridge sides and the GaInP etching stop layer of the ridge bottom end vicinity, and further forms on the GaInP etching stop layer of the ridge flanks through the insulating film. As mentioned above, according to the invention, this has the configuration that the superlattice active layer section is sandwiched between the n-AlInP clad layer and the p-AlInP first clad layer and that the p-side electrode directly covers the ridge top surface, the slant ridge sides and the compound semiconductor layer of the ridge flanks. Consequently, the semiconductor laser device according to the present invention can achieve the semiconductor laser device of the high light output efficiency, which has the structure of high current confinement effect, and is small in the leak current, and favorable in the temperature property, and low in the leak current and can effectively confine the laser light to the stripe region, and is favorable in the beam profile.

Also, according to the first embodiment method, this attains the manufacturing method preferable for manufacturing the semiconductor laser device according to the first embodiment. In short, the first embodiment method has the merit that it does not require the second epitaxial growing step, because the p-side electrode is directly formed on the GaInP etching stop layer of the ridge flanks, the ridge sides and the ridge top surface, without re-growing the compound semiconductor layer on the ridge flanks after the formation of the ridge.

According to the second and third embodiments, it is possible to consequently increase the effect of suppressing the leak current, in addition to the effect of the first invention, and improve the mount control property when mounting the semiconductor laser device, and the heat radiation property and the like.

Also, according to the second embodiment method, this has the effect similar to the first embodiment method, and achieves the manufacturing method preferable for manufacturing the semiconductor laser devices according to the second and third embodiments.

### BRIEF DESCRIPTION OF THE DRAWINGS

Fig. 1 is a sectional view showing a configuration of a semiconductor laser device in a first embodiment;
Figs. 2A to 2F are sectional views for each step when a semiconductor laser device is manufactured in accordance with a method in a second embodiment, respectively;
Fig. 3 is a graph of a light output - current property;
Fig. 4 is a graph of a property temperature;
Fig. 5 is a graph of NFP;
Fig. 6 is a sectional view showing a laminated structure of a gain waveguide type semiconductor laser device in a referential example;
Fig. 7 is a sectional view showing a configuration of a semiconductor laser device in a third embodiment;
Figs. 8A to 8C are sectional views of a main step when a semiconductor laser device is manufactured in accordance with a method in a fourth embodiment, respectively;
Fig. 9 is a sectional view showing a configuration of a semiconductor laser device in a fifth embodiment;
Figs. 10A to 10C are sectional views of main steps when a semiconductor laser device is manufactured in accordance with a method in a sixth embodiment, respectively;
Fig. 11 is a sectional view showing a configuration of a conventional first semiconductor laser device;
Figs. 12A to 12F are sectional views for each step when a conventional first semiconductor laser device is manufactured, respectively;
Fig. 13 is a sectional view showing a configuration of a conventional second semiconductor laser device; and
Fig. 14 is a sectional view showing a configuration of a conventional third semiconductor laser device.

### BEST MODE FOR CARRYING OUT INVENTION

The present invention will be described below in detail on the basis of embodiments with reference to the attached drawings. By the way, a film forming method, a composition and film thickness of a compound semiconductor layer, a ridge width, a process condition and the like, which are described in the following embodiments, are exemplified in order to easily understand the present invention.

### (First Embodiment)

### Embodiment of Semiconductor Laser Device

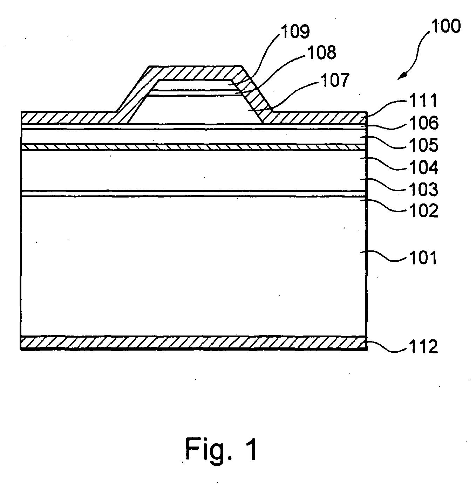

This embodiment is one example of the realization of the semiconductor laser device according to the first present embodiment, and Fig. 1 is a sectional view showing the configuration of the semiconductor laser device in this embodiment.

A semiconductor laser device 100 in this embodiment includes the laminated structure of a buffer layer 102, a clad layer 103 made of n-Al_{0.5}In_{0.5}P, a superlattice active layer section 104, a first clad layer 105 made of p-Al_{0.5}In_{0.5}P, an etching stop layer 106 made of GaInP, a second clad layer 107 made of p-Al_{0.5}In_{0.5}P, a protective layer 108 made of GaInP and a contact layer 109 made of p-GaAs, which are sequentially grown on an n-GaAs substrate 101, as shown in Fig. 1.

The buffer layer 102 is a buffer layer composed of at least one of an n-GaAs layer or an n-GaInP layer.

In the laminated structure, the p-AlInP second clad layer 107, the GaInP protective layer 108 and the p-GaAs contact layer 109 are processed into a stripe-shaped ridge whose ridge width is 60 µm.

A p-side electrode 111 is directly coated and formed on the GaInP etching stop layer 106 of ridge top surface, slant ridge sides and ridge flanks, and an n-side electrode 112 is formed on the rear of the n-GaAs substrate 101.

The superlattice active layer section 104 is constituted as the SCH (Separated Confinement Heterostructure) structure composed of at least one layer of a quantum well layer, which is sandwiched between a barrier layer and an optical guide layer. The quantum well layer is made of AlₓGa₁₋ₓInP (0<x≤1, x=0 in this embodiment), and the barrier layer and the optical guide layer are made of Al_{y}Ga_{1-y}InP (0<y≤1, y=0.6 in this embodiment), and the Al composition has the relation of (x<y).

In this embodiment, the superlattice active layer section 104 is formed as SQW (Single Quantum Well) structure.

In the semiconductor laser device 100 in this embodiment, with regard to film thicknesses of the respective compound semiconductor layers, a film thickness of the buffer layer 102 is 0.03 µm and a film thickness of the n-AlInP n-type clad layer 103 is 2.00 µm, and with regard to film thicknesses of the SCH superlattice active layer section 104, the optical guide layer is 0.12 µm and the quantum well layer is 12 nm, and a layer thickness of the p-AlInP first p-type clad layer 105 is 0.40 µm, a layer thickness of the GaInP etching stop layer 106 is 15 nm, a layer thickness of the p-AlInP second p-type clad layer 107 is 1.6 µm, a layer thickness of the GaInP protective layer 108 is 30 nm, and a layer thickness of the p-GaAs contact layer 109 is 0.26 µm.

Also, a carrier concentration of the p-GaAs contact layer 109 of the ridge top surface is 2 to 3 × 10¹⁹ cm⁻³, and higher than carrier concentrations 1 to 2 × 10¹⁸ cm⁻³ of the p-AlInP first p-type clad layer 105 and the p-AlInP second p-type clad layer 107.

The p-side electrode 111 is configured as the multilayer film in which a Ti film having a layer thickness of 0.05 µm, a Pt film of 0.1 µm and an Au film of 0.2 µm are deposited on the p-GaAs contact layer 109.

As mentioned above, by setting the layer thicknesses of the p-AlInP first p-type clad layer 105, the GaInP etching stop layer 106, the p-AlInP second p-type clad layer 107, the GaInP protective layer 108 and the p-GaAs contact layer 109, the ridge height becomes 1.89 µm.

Due to the above-mentioned configuration, in the semiconductor laser device 100 in this embodiment, current injected into the p-GaAs contact layer 109 is current-narrowed in the region of the p-AlInP second p-type clad layer 107 formed into the stripe-shaped ridge, and sent to the superlattice active layer section 104, and generates laser oscillation.

In the semiconductor laser device 100 in this embodiment, the efficient current confinement action is carried out, and the light oozed from the superlattice active layer section 104 is reflected by the boundary plane of the p-side electrode 111. Consequently, the light loss is reduced, which enables the laser light to be effectively confined inside a stripe region.

Although the p-side electrode 111 is also evaporated on the GaInP etching stop layer 106 on the ridge sides and the ridge flanks, a p-type dopant concentration is thin on this junction plane, which leads to Schottky junction so that the current does not flow. The current is injected from the p-side electrode 111, and flows through the region of the p-GaAs contact layer 109 in which the p-type dopant concentration on the ridge top surface is high, and arrives at the superlattice active layer section 104.

In this way, the semiconductor laser device 100 in this embodiment is configured such that it has the structure whose current confinement effect is high, and such that the light oozed from the superlattice active layer section 104 is reflected by the boundary plane between the p-side electrode 111 and the GaInP etching stop layer 106, and such that the light loss is consequently reduced which enables the laser light to be effectively confined inside the stripe region.

By the way, in this embodiment, the superlattice active layer section 104 is defined as the SQW (Single Quantum Well) structure, and with regard to the layer thickness of the SCH active layer structure, the optical guide layer is 0.12 µm, and the quantum well layer is 12 nm. However, as long as the specification of a vertical radiation angle property and the like is satisfied, even the MQW is allowable, and the design of other layer structures is allowable.

### (Second Embodiment)

### Embodiment of Manufacturing Method of Semiconductor Laser Device

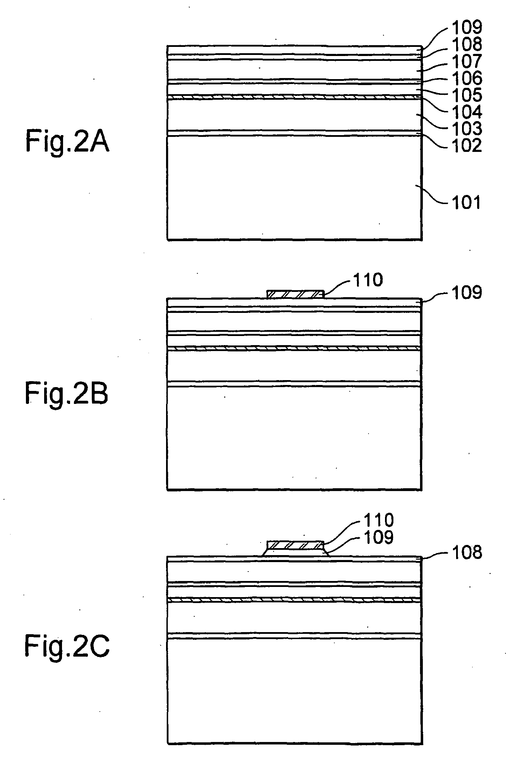

This embodiment is one example a manufacturing method of the semiconductor laser device according to the first embodiment method is applied to the manufacturing of the above-mentioned semiconductor laser device 100. Figs. 2A to 2F are sectional views for each step when the above-mentioned semiconductor laser device 100 is manufactured in accordance with the method in this embodiment, respectively.

In this embodiment, at first, as shown in Fig. 2A, the metal-organic vapor phased growing method, such as the MOVPE method, the MOCVD method or the like, is used to sequentially epitaxially grow a buffer layer 102, an n-AlInP n-type clad layer 103, a superlattice active layer section 104, a p-AlInP first p-type clad layer 105, a GaInP etching stop layer 106, a p-AlInP second p-type clad layer 107, a GaInP protective layer 108 and a p-GaAs contact layer 109, on a n-GaAs substrate 101, thereby forming a lamination layer body having the double hetero-structure.

The buffer layer 102 is composed of at least one layer of the n-GaAs layer and the n-GaInP layer.

At this time, as the dopant, Si and Se are used on the n-side, and Zn, Mg, Be and the like are used on the p-side.

Next, as shown in Fig. 2B, a resist film is formed on the p-GaAs contact layer 109 of the formed lamination layer body, and patterned by the photographic etching, thereby forming a stripe-shaped resist mask 110.

Next, as shown in Fig. 2C, from above the resist mask 110, the p-GaAs contact layer 109 is etched and processed into the stripe-shaped ridge, and the GaInP protective layer 108 is exposed. In etching, the etchant that can selectively remove the p-GaAs, for example, the phosphoric-acid-based etchant is used to carry out the etching.

Since the phosphoric-acid-based etchant is used to etch the p-GaAs contact layer 109, the progress of the etching is stopped in the GaInP protective layer 108, and the p-AlInP second p-type clad layer 107 is not exposed in air. Thus, it is not oxidized.

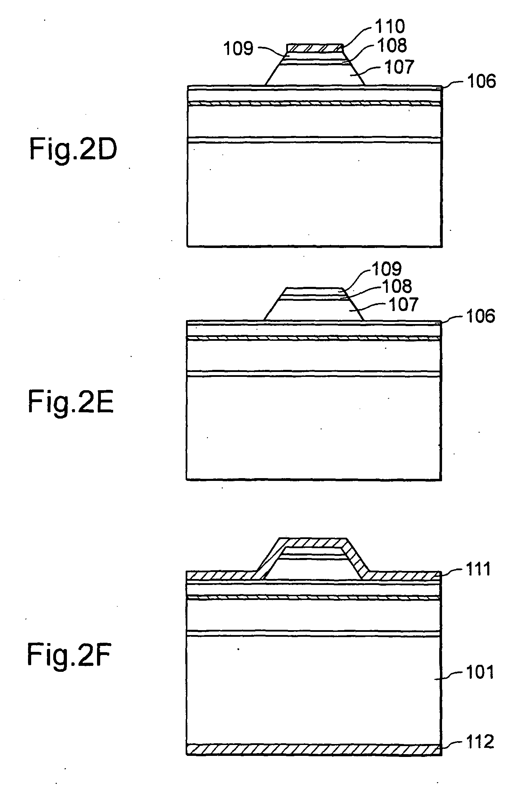

Next as shown in Fig. 2D, the GaInP protective layer 108 and the p-AlInP second p-type clad layer 107 are etched. For the etchant, for example, the hydrochloric-acid-based etchant is used.

At this time, if the etching is performed in a period longer than necessary, the progress of the etching causes the GaInP etching stop layer 106 to be penetrated. Thus, the control of the etching period is required. This embodiment uses the etchant having the composition (volume ratio) of acetic acid (99.5 % or more) : hydrogen peroxide (31 %) : hydrochloric acid (36 %) = 100 : 1 : 10, and carries out the etching for 3 minutes and 30 seconds. In the etching, stirring is not performed.

The GaInP protective layer 108 is quickly removed at the moment when the lamination layer body is dipped into the etchant, and the etching of the p-AlInP second p-type clad layer 107 is then started.

The etching speed of the AlInP is faster than the GaInP that is the protective layer 108. However, since the stirring is not performed, the permeation of the etchant is small, and the etching speed becomes slower as the etching time elapses. After the elapse of a predetermined time, when the GaInP etching stop layer 106 begins to be exposed, the apparent etchant concentration on a wafer surface is thin. Thus, the selectivity is exhibited.

Also, in the etching, since in the ridge sides vicinity, there are the p-GaAs contact layer 109 and the resist mask 110, the permeation of the etchant becomes significant, and the etching is faster than the other flat portions.

For this reason, in the ridge vicinity, the p-AlInP second p-type clad layer 107 is removed to expose the GaInP etching stop layer 106. On the contrary, the p-AlInP second p-type clad layer 107 remains on the region away from the ridge. However, the current confinement action and the light confinement are carried out only in the ridge vicinity region. Thus, even if the p-AlInP second p-type clad layer 107 remains on the region away from the ridge, there is no case that a problem is induced in the laser property.

Also, in the etching, after the elapse of about two minutes from the etching start, the resist mask 110 begins to be eroded by the etchant. However, since instead of the resist mask 110, the p-GaAs contact layer 109 that is not eroded by the etchant acts the role of the mask, there is no problem on the etching control.

Next, as shown in Fig. 2E, the stripe-shaped resist mask 110 is removed to expose the p-GaAs contact layer 109.

Next, as shown in Fig. 2F, Ti/Pt/Au multilayer film is evaporated on the entire surface of the ridge top surface, the ridge sides and the GaInP etching stop layer 106 of the ridge flanks, and the p-side electrode 111 is formed. After the rear of the n-GaAs substrate 101 is polished and adjusted to a predetermined substrate thickness, the n-side electrode 112 is formed on the substrate rear. Consequently, it is possible to obtain the semiconductor wafer for the laser having the structure shown in Fig. 1.

Next, by cleaving the semiconductor wafer for the laser in the ridge stripe direction and the vertical direction, it is possible to manufacture the semiconductor laser device 100 having a pair of resonator reflection surfaces.

This embodiment uses the etchant composed of acetic acid : hydrogen peroxide : hydrochloric acid, and carries out the wet etching, and consequently forms the ridge. Thus, the action of the above-mentioned etching mechanism makes the control of the ridge shape easier.

Also, since this embodiment does not require the second epitaxial growing step, the process is simple.

By the way, in the semiconductor laser device 100 in this embodiment, the respective compound semiconductor layers are epitaxially grown by using the metal-organic vapor phased growing method, such as the MOVEP method, the MOCVD method or the like. However, it is not limited thereto. The film may be formed, for example, by using an MBE (Molecular Beam Epitaxy) method or the like.

Also, this embodiment is designed such that a layer thickness of the p-AlInP first p-type clad layer 105 is 0.40 µm, a layer thickness of the GaInP etching stop layer 106 is 15 nm, and a layer thickness of the p-AlInP second p-type clad layer 107 is 1.6 µm. However, in designing the lateral radiation angle property and the like, any layer structure may be designed.

By the way, if the clad layer structure different from this embodiment is employed in designing the lateral radiation angle property and the like, on the process, it is obviously allowable to change the concentration of acetic acid : hydrogen peroxide : hydrochloric acid and the etching period so as to make the etching control easier.

Also, in this embodiment, when the GaInP etching stop layer 106 is exposed, the etching is stopped. Then, on the top surface thereof, the p-side electrode 111 is evaporated on the entire surface of the ridge top surface, the ridge sides and the GaInP etching stop layer 106 of the ridge flanks. However, it may be configured such that after the p-AlInP second lad layer 107 is etched, the GaInP etching stop layer 106 is further removed and the p-AlInP first clad layer 105 is exposed and the p-side electrode 111 is formed thereon.

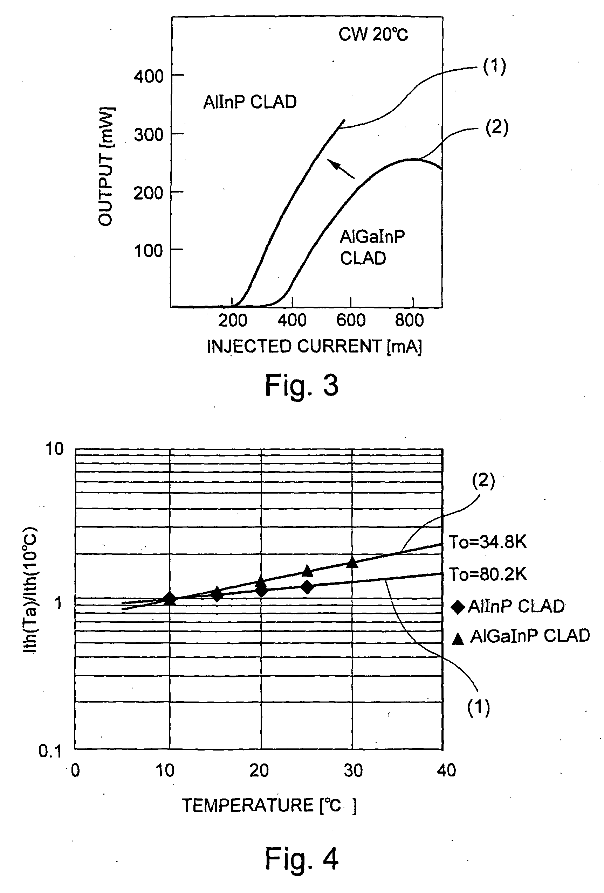

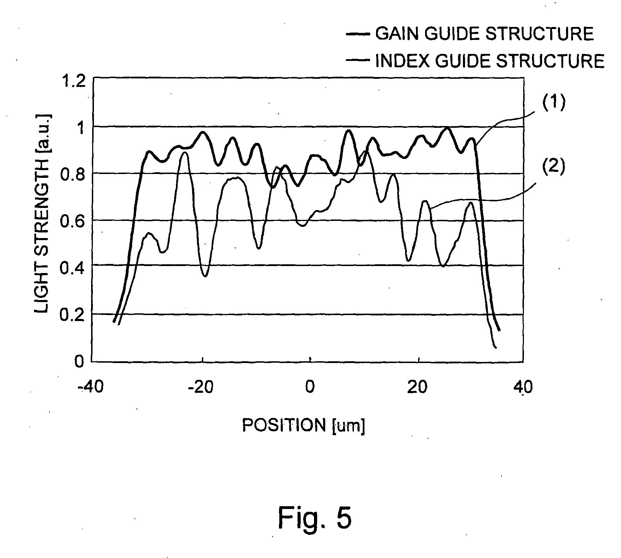

In order to evaluate the semiconductor laser device 100 of single stripe manufactured in accordance with the method in this embodiment the light output - current property, the property temperature and the NFP are measured, and a graph (1) of Fig. 3, a graph (1) of Fig. 4 and a graph (1) of Fig. 5 are respectively obtained.

In Fig. 4, a horizontal axis indicates a temperature, and a vertical axis indicates Ith(Ta)/Ith(10°C). The Ith(Ta) is an oscillation threshold current at a time of a measurement temperature Ta °C, and the Ith(10°C) is an oscillation threshold current at a time of a measurement temperature of 10 °C. T₀ is a property temperature represented by T₀=(T₂-T₁)/ln(I₂/I₁).

The graph (2) of Fig. 3 is the light output - current property of the above-mentioned conventional first semiconductor laser device 500 in which the AlGaInP serves as the clad layer. As can be understood from Fig. 3, the semiconductor laser device 100 in this embodiment indicates the favorable light output - current property, which is low in the threshold current, as compared with the semiconductor laser device in which the AlGaInP serves as the clad layer.

Also, the graph (2) of Fig. 4 is the temperature property of the above-mentioned conventional first semiconductor laser device 500 in which the AlGaInP serves as the clad layer. As can be understood from Fig. 3, in the semiconductor laser device 100 in this embodiment, as compared with the semiconductor laser device in which the AlGaInP serves as the clad layer, the value of the To is high, and the temperature property is favorable.

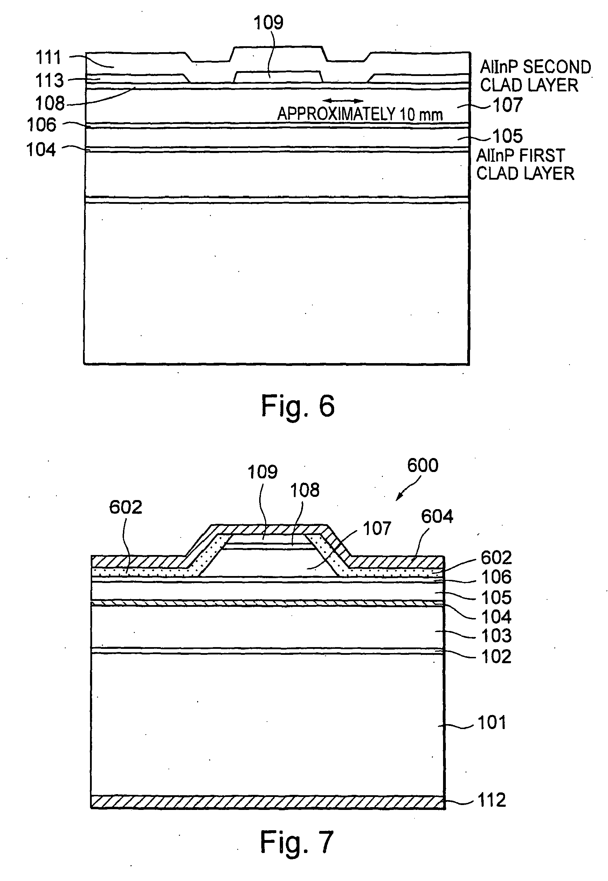

Also, the graph (2) of Fig. 5 is the measurement result of NFP of a gain guide type semiconductor laser device manufactured as a referential example. The semiconductor laser device of the referential example is the gain guide type semiconductor laser device having a laminated structure shown in Fig. 6. The film thicknesses and compositions of the respective compound semiconductor layers and the p-side electrode are equal to the semiconductor laser device 100 except the SiO₂ film 113.

As can be understood from Fig. 5, the NFP of the semiconductor laser device 100 in this embodiment indicates the NFP of the top hat type that is sharp and favorable. On the other hand, the NFP of the semiconductor laser device of the referential example indicates the multimodal property, and this is not preferred as the high output semiconductor laser device.

### (Third Embodiment)

### Embodiment of Semiconductor Laser Device

This embodiment is one example of a semiconductor laser device according to a second embodiment, and Fig. 7 is a sectional view showing the configuration of the semiconductor laser device in this embodiment.

A semiconductor laser device 600 in this embodiment has the configuration equal to the configuration of the semiconductor laser device 100 in the first embodiment, except that the ridge sides and the ridge flanks contain insulating films, and the p-side electrode is extended to the ridge sides and the ridge flanks through the insulating films, in addition to the ridge top surface, as shown in Fig. 7. The same symbols are given to the portions equal to Fig. 1, among the portions shown in Fig. 7.

In short, the semiconductor laser device 600 in this embodiment includes the laminated structure of a buffer layer 102, a clad layer 103 made of n-Al_{0.5}In_{0.5}P, a superlattice active layer section 104, a first clad layer 105 made of p-Al_{0.5}In_{0.5}P, an etching stop layer 106 made of GaInP, a second clad layer 107 made of p-Al_{0.5}In_{0.5}P, a protective layer 108 made of GaInP and a contact layer 109 made of p-GaAs, which are sequentially grown on an n-GaAs substrate 101, similarly to the semiconductor laser device 100 in the first embodiment.

The buffer layer 102 is a buffer layer composed of at least one of an n-GaAs layer or n n-GaInP layer.

In the laminated structure, the p-AlInP second clad layer 107, the GaInP protective layer 108 and the p-GaAs contact layer 109 are processed into a stripe-shaped ridge whose ridge width is 60 µm.

Differently from the semiconductor laser device 100 in the first embodiment, in the semiconductor laser device 600 in this embodiment, an insulating film 602 having a film thickness of 0.25 µm is formed on the ridge sides and the GaInP etching stop layer 106 of the ridge flanks except the ridge top surface, and the p-GaAs contact layer 109 is exposed through the opening of the ridge top surface. For example, SiO₂, SiN, AlN and the like are used, as the insulating film 602.

A p-side electrode 604 is formed on the p-GaAs contact layer 109 through an opening of the insulating film 602, and further formed on the ridge sides and the GaInP etching stop layer 106 of the ridge flanks through the insulating film 602.

Also, the n-side electrode 112 is formed on the rear of the n-GaAs substrate 101.

The superlattice active layer section 104 is constituted as the SCH (Separated Confinement Heterostructure) structure composed of at least one layer of the quantum well layer, which is sandwiched between the barrier layer and the optical guide layer. The quantum well layer is made of the AlₓGa₁₋ₓInP (0<x≤1, x=0 in this embodiment), and the barrier layer and the optical guide layer are made of the Al_{y}Ga_{1-y}InP (0<y≤1, y=0.6 in this embodiment), and the Al composition has the relation of (x<y).

In this embodiment, the superlattice active layer section 104 formed as the SQW (Single Quantum Well) structure.

In the semiconductor laser device 600 in this embodiment, with regard to the film thicknesses of the respective compound semiconductor layers, the film thickness of the buffer layer 102 is 0.03 µm and the film thickness of the n-AlInP n-type clad layer 103 is 2.00 µm, and with regard to the film thicknesses of the SCH superlattice active layer section 104, the optical guide layer is 0.12 µm and the quantum well layer is 12 nm, and the layer thickness of the p-AlInP first p-type clad layer 105 is 0.40 µm, the layer thickness of the GaInP etching stop layer 106 is 15 nm, the layer thickness of the p-AlInP second p-type clad layer 107 is 1.6 µm, the layer thickness of the GaInP protective layer 108 is 30 nm, and the layer thickness of the p-GaAs contact layer 109 is 0.26 µm.

Also, the carrier concentration of the p-GaAs contact layer 109 of the ridge top surface is 2 to 3 × 10¹⁹ cm⁻³, and higher than the carrier concentrations 1 to 2 × 10¹⁸ cm⁻³ of the p-AlInP first p-type clad layer 105 and the p-AlInP second p-type clad layer 107.

Also, the p-side electrode 111 is configured as the multilayer film in which a Ti film having a layer thickness of 0.05 µm, a Pt film of 0.1 µm and an Au film of 0.2 µm are deposited on the insulating film 602 and the p-GaAs contact layer 109.

As mentioned above, by setting the layer thicknesses of the p-AlInP first p-type clad layer 105, the GaInP etching stop layer 106, the p-AlInP second p-type clad layer 107, the GaInP protective layer 108 and the p-GaAs contact layer 109, the ridge height becomes 1.89 µm.

Due to the above-mentioned configuration, in the semiconductor laser device 600 in this embodiment, the current injected into the p-GaAs contact layer 109 is current-narrowed in the region of the p-AlInP second p-type clad layer 107 formed into the stripe-shaped ridge, and sent to the superlattice active layer section 104, and generates the laser oscillation.

In the semiconductor laser device 600 in this embodiment, the efficient current confinement action is carried out, and the light oozed from the superlattice active layer section 104 is reflected by the boundary plane of the p-side electrode 111. Consequently, the light loss is reduced, which enables the laser light to be effectively confined inside the stripe region.

Although the p-side electrode 111 is also evaporated on the ridge sides and the GaInP etching stop layer 106 of the ridge flanks, in addition to the interposition through the insulating film 602, the p-type dopant concentration is thin on this junction plane, which leads to the Schottky junction so that the current does not flow. The current is injected from the p-side electrode 111, and flows through the region of the p-GaAs contact layer 109 in which the p-type dopant concentration of the ridge top surface is high, and arrives at the superlattice active layer section 104.

In this way, the semiconductor laser device 600 in this embodiment is designed such that it has the structure whose current confinement effect is high, and the light oozed from the superlattice active layer section 104 is reflected by the boundary plane between the p-side electrode 111 and the GaInP etching stop layer 106, and the light loss is consequently reduced which enables the laser light to be effectively confined inside the stripe region.

Moreover, in this embodiment, since the insulating film 602 is provided, it is possible to increase the effect of suppressing the leak current, and improve the mount control property when mounting the semiconductor laser device, and the heat radiation property and the like.

By the way, in this embodiment, the superlattice active layer section 104 is defined as the SQW (Single Quantum Well) structure, and with regard to the layer thickness of the SCH active layer structure, the optical guide layer is 0.12 µm, and the quantum well layer is 12 nm. However, as long as the specification of the vertical radiation angle property and the like is satisfied, even the MQW is allowable, and the design of the other layer structures is allowable.

### (Fourth Embodiment)

### Embodiment of Manufacturing Method of Semiconductor Laser Device

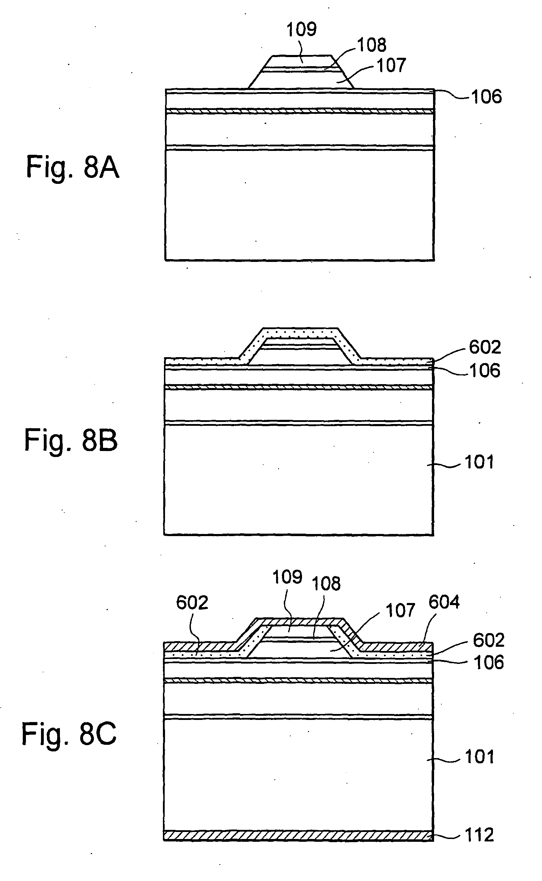

This embodiment is one example of a manufacturing method of the semiconductor laser device according to the second embodiment method is applied to the manufacturing of the above-mentioned semiconductor laser device 600. Figs. 8A to 8C are sectional views for each step when the above-mentioned semiconductor laser device 600 is manufactured in accordance with the method in this embodiment, respectively. The same symbols are given to the portions equal to Figs. 2A to 2F, among the portions shown in Figs. 8A to 8C.

In this embodiment, at first, similarly to the second embodiment, the metal-organic vapor phased growing method, such as the MOVPE method, the MOCVD method or the like, is used to sequentially epitaxially grow a buffer layer 102, an n-AlInP n-type clad layer 103, a superlattice active layer section 104, a p-AlInP first p-type clad layer 105, a GaInP etching stop layer 106, a p-AIInP second p-type clad layer 107, a GaInP protective layer 108 and a p-GaAs contact layer 109, on n n-GaAs substrate 101, thereby generating a lamination layer body having the double hetero-structure.

The buffer layer 102 is composed of at least one layer of an n-GaAs layer of a n-GaInP layer.

At this time, as the dopant, Si and Se are used on the n-side, and Zn, Mg, Be and the like are used on the p-side.

Next, the resist film is formed on the p-GaAs contact layer 109 of the formed lamination layer body, and patterned by the photographic etching, thereby forming the stripe-shaped resist mask 110 (refer to Fig. 2B). Then, from above the resist mask 110, the p-GaAs contact layer 109 is etched and processed into the stripe-shaped ridge, and the GaInP protective layer 108 is exposed. In etching, the etchant that can selectively remove the p-GaAs, for example, the phosphoric-acid-based etchant is used to carry out the etching.

Since the phosphoric-acid-based etchant is used to etch the p-GaAs contact layer 109, the progress of the etching is stopped in the GaInP protective layer 108, and the p-AlInP second p-type clad layer 107 is not exposed in the air. Thus, it is not oxidized.

Next, the GaInP protective layer 108 and the p-AlInP second p-type clad layer 107 are etched. For the etchant, for example, the hydrochloric-acid-based etchant is used.

At this time, if the etching is performed in the period longer than necessary, the progress of the etching causes the GaInP etching stop layer 106 to be penetrated. Thus, the control of the etching period is required. This embodiment uses the etchant having the composition (volume ratio) of acetic acid (99.5 % or more) : hydrogen peroxide (31 %) : hydrochloric acid (36 %) = 100 : 1 : 10, and carries out the etching for 3 minutes and 30 seconds. In the etching, the stirring is not performed.

The GaInP protective layer 108 is quickly removed at the moment when the lamination layer body is dipped into the etchant, and the etching of the p-AlInP second p-type clad layer 107 is then started.

The etching speed of the AlInP is faster than the GaInP that is the protective layer 108. However, since the stirring is not performed, the permeation of the etchant is small, and the etching speed becomes slower as the etching time elapses. After the elapse of the predetermined time, when the GaInP etching stop layer 106 begins to be exposed, the apparent etchant concentration on the wafer surface is thin. Thus, the selectivity is exhibited.

Also, in the etching, since in the ridge sides vicinity, there are the p-GaAs contact layer 109 and the resist mask 110, the permeation of the etchant becomes significant, and the etching is faster than the other flat portions.

For this reason, in the ridge vicinity, the p-AlInP second p-type clad layer 107 is removed to expose the GaInP etching stop layer 106. On the contrary, the p-AlInP second p-type clad layer 107 remains on the region away from the ridge. However, the current confinement action and the light confinement are carried out only in the ridge vicinity region. Thus, even if the p-AlInP second p-type clad layer 107 remains on the region away from the ridge, there is no case that a problem is induced in the laser property.

Also, in the etching, after the elapse of about two minutes from the etching start, the resist mask 110 begins to be eroded by the etchant. However, since instead of the resist mask 110, the p-GaAs contact layer 109 that is not eroded by the etchant acts the role of the mask, there is no problem on the etching control.

Next, similarly to the semiconductor laser device 100 in the first embodiment, as shown in Fig. 8A, the stripe-shaped resist mask 110 is removed to expose the p-GaAs contact layer 109.

Next, as shown in Fig. 8B, the insulating film 602 is formed on the entire surface of the ridge top surface, the ridge sides and the GaInP etching stop layer 106 of the ridge flanks.

Next, as shown in Fig. 8C, the insulating film 602 of the ridge top surface is etched to expose the p-GaAs contact layer 109. In succession, the Ti/Pt/Au multilayer film is evaporated on the entire surface of the p-GaAs contact layer 109 of the ridge top surface and on the insulating film 602 of the ridge sides and the ridge flanks, and the p-side electrode 604 is then formed.

After the rear of the n-GaAs substrate 101 is polished and adjusted to the predetermined substrate thickness, an n-side electrode 112 is formed on the substrate rear. Consequently, it is possible to obtain the semiconductor wafer for the laser having the structure shown in Fig. 7.

Next, by cleaving the semiconductor wafer for the laser in the ridge stripe direction and the vertical direction, it is possible to manufacture the semiconductor laser device 600 having a pair of resonator reflection surfaces.

This embodiment uses the etchant composed of acetic acid : hydrogen peroxide : hydrochloric acid, and carries out the wet etching, and forms the ridge. Thus, the action of the above-mentioned etching mechanism makes the control of the ridge shape easier.

Also, since this embodiment does not require the second epitaxial growing step, the process is simple.

By the way, in the semiconductor laser device 600 in this embodiment, the respective compound semiconductor layers are epitaxially grown by using the metal-organic vapor phased growing method, such as the MOVEP method, the MOCVD method or the like. However, it is not limited thereto. The film may be formed, for example, by using the MBE (Molecular Beam Epitaxy) method or the like.

Also, this embodiment is designed such that the layer thickness of the p-AlInP first p-type clad layer 105 is 0.40 µm, the layer thickness of the GaInP etching stop layer 106 is 15 nm, and the layer thickness of the p-AlInP second p-type clad layer 107 is 1.6 µm. However, in designing the lateral radiation angle property and the like, any layer structure may be designed.

By the way, if the clad layer structure different from this embodiment is employed in designing the lateral radiation angle property and the like, on the process, it is obviously allowable to change the concentration of acetic acid : hydrogen peroxide : hydrochloric acid and the etching period so as to make the etching control easier.

Also, in this embodiment, when the GaInP etching stop layer 106 is exposed, the etching is stopped. Then, on the top surface thereof, the p-side electrode 111 is evaporated on the entire surface of the ridge top surface, the ridge sides and the GaInP etching stop layer 106 of the ridge flanks. However, it may be configured such that after the p-AlInP second clad layer 107 is etched, the GaInP etching stop layer 106 is further removed and the p-AlInP first clad layer 105 is exposed and the insulating film 602 is formed thereon.

### (Fifth Embodiment)

### Embodiment of Semiconductor Laser Device

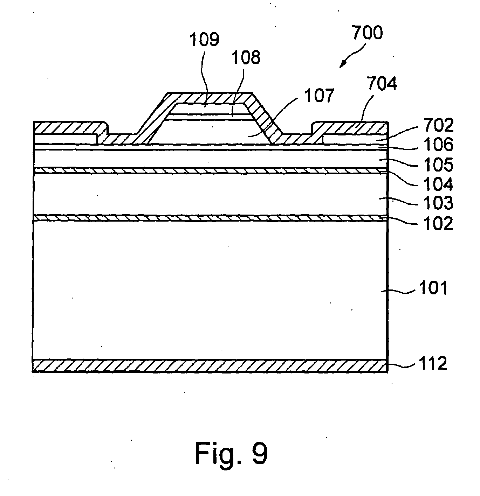

This embodiment is one example of a realization of a semiconductor laser device according to a third embodiment, and Fig. 9 is a sectional view showing the configuration of the semiconductor laser device in this embodiment.

A semiconductor laser device 700 in this embodiment has the configuration equal to the configuration of the semiconductor laser device 600 in the third embodiment, except that only a ridge sides contains an insulating film, and a part of a p-side electrode is provided through the insulating film. The same symbols are given to the portions equal to Fig. 7, among the portions shown in Fig. 9.

In short, the semiconductor laser device 700 in this embodiment includes the laminated structure of a buffer layer 102, a clad layer 103 made of n-Al_{0.5}In_{0.5}P, a superlattice active layer section 104, a first clad layer 105 made of p-Al_{0.5}In_{0.5}P, an etching stop layer 106 made of GaInP, a second clad layer 107 made of p-Al_{0.5}In_{0.5}P, a protective layer 108 made of GaInP and a contact layer 109 made of p-GaAs, which are sequentially grown on an n-GaAs substrate 101, similarly to the semiconductor laser device 600 in the sixth embodiment.

The buffer layer 102 is a buffer layer composed of at least one of an n-GaAs layer or an n-GaInP layer.

In the laminated structure, the p-AlInP second clad layer 107, the GaInP protective layer 108 and the p-GaAs contact layer 109 are processed into a stripe-shaped ridge whose ridge width is 60 µm.

Also, a carrier concentration of the p-GaAs contact layer 109 of the ridge top surface is 2 to 3 × 10¹⁹ cm⁻³, and higher than carrier concentrations 1 to 2 × 10¹⁸ cm⁻³ of the p-AlInP first p-type clad layer 105 and the p-AlInP second p-type clad layer 107.

Differently from the semiconductor laser device 600 in the third embodiment, in the semiconductor laser device 700 in this embodiment, an insulating film 702 is formed only on the GaInP etching stop layer 106 in the region separated from a ridge bottom end, and is not formed on the ridge top surface, the ridge sides and the ridge bottom end vicinity. Then, it serves as an opening, which causes the p-GaAs contact layer 109 of the ridge top surface and the GaInP etching stop layer 106 of the ridge sides and the ridge bottom end vicinity to be exposed in the stripe-shaped manner. A film thickness of the insulating film 702 is 0.25 µm. For example, SiO₂, SiN, AIN and the like are used, as the insulating film 702.

A p-side electrode 704 is formed on the p-GaAs contact layer 109, which is exposed from the opening of the insulating film 702, and on the GaInP etching stop layer 106 of the ridge sides and the ridge bottom end vicinity, and further formed on the GaInP etching stop layer 106 of the ridge flanks through the insulating film 602.

Also, an n-side electrode 112 is formed on the rear of the n-GaAs substrate 101.

In this embodiment, in addition to the effect of the semiconductor laser device 100 in the first embodiment, since the insulating film 702 is provided, it is possible to increase the effect of suppressing the leak current, and improve the mount control property when mounting the semiconductor laser device, and the heat radiation property and the like

### (Sixth Embodiment)

### Embodiment of Manufacturing Method of Semiconductor Laser Device

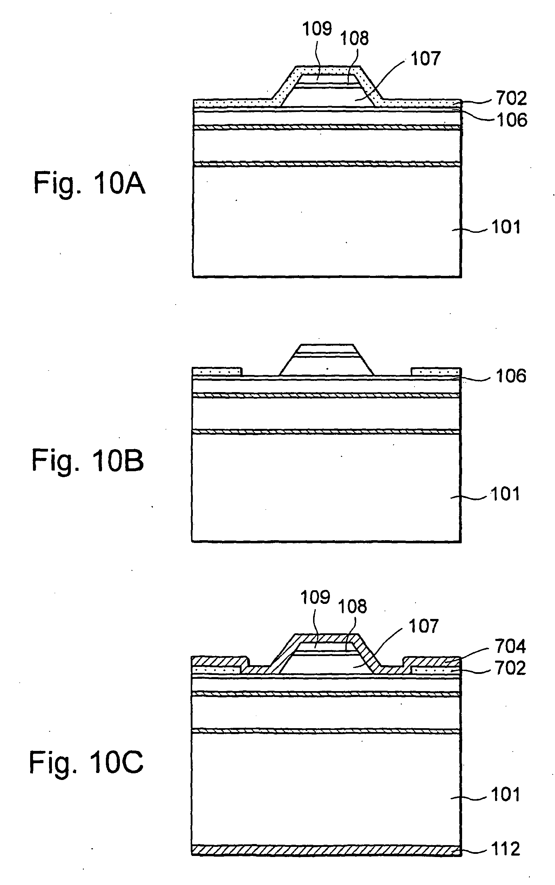

This embodiment is one example of a manufacturing method of the semiconductor laser device according to the second embodiment method is applied to the manufacturing of the above-mentioned semiconductor laser device 700. Figs. 10A to 10C are sectional views of the main steps when the above-mentioned semiconductor laser device 700 is manufactured in accordance with the method in this embodiment, respectively. The same symbols are given to the portions equal to Figs. 8A to 8C, among the portions shown in Figs. 10A to 10C.

In this embodiment, at first, similarly to the fourth embodiment, the metal-organic vapor phased growing method, such as the MOVPE method, the MOCVD method or the like, is used to sequentially epitaxially grow the buffer layer 102, the n-type clad layer 103 made of n-AlInP, the superlattice active layer section 104, the p-AlInP first p-type clad layer 105, the GaInP etching stop layer 106, the p-AlInP second p-type clad layer 107, the GaInP protective layer 108 and the p-GaAs contact layer 109, on the n-GaAs substrate 101, thereby forming a lamination layer body having the double hetero-structure.

The buffer layer 102 is composed of at least one layer of an n-GaAs layer or an n-GaInP layer.

At this time, as the dopant, Si and Se are used on the n-side, and Zn, Mg, Be and the like are used on the p-side.

Next, a resist film is formed on the p-GaAs contact layer 109 of the formed lamination layer body, and patterned by the photographic etching, thereby forming a stripe-shaped resist mask 110 (refer to Fig. 2B). Then, from above the resist mask 110, the p-GaAs contact layer 109 is etched and processed into the stripe-shaped ridge, and the GaInP protective layer 108 is exposed. In etching, the etchant that can selectively remove the p-GaAs, for example, the phosphoric-acid-based etchant is used to carry out the etching.

Since the phosphoric-acid-based etchant is used to etch the p-GaAs contact layer 109, the progress of the etching is stopped in the GaInP protective layer 108, and the p-AlInP second p-type clad layer 107 is not exposed in the air. Thus, it is not oxidized.

Next, the GaInP protective layer 108 and the p-AlInP second p-type clad layer 107 are etched. For the etchant, for example, the hydrochloric-acid-based etchant is used.

At this time, if the etching is performed in the period longer than necessary, the progress of the etching causes the GaInP etching stop layer 106 to be penetrated. Thus, the control of the etching period is required. This embodiment uses the etchant having the composition (volume ratio) of acetic acid (99.5 % or more) : hydrogen peroxide (31 %) : hydrochloric acid (36 %) = 100 : 1 : 10, and carries out the etching for 3 minutes and 30 seconds. In the etching, the stirring is not performed.

The GaInP protective layer 108 is quickly removed at the moment when the lamination layer body is dipped into the etchant, and the etching of the p-AlInP second p-type clad layer 107 is then started.

The etching speed of the AlInP is faster than the GaInP that is the protective layer 108. However, since the stirring is not performed, the permeation of the etchant is small, and the etching speed becomes slower as the etching time elapses. After the elapse of the predetermined time, when the GaInP etching stop layer 106 begins to be exposed, the apparent etchant concentration on the wafer surface is thin. Thus, the selectivity is exhibited.

Also, in the etching, since in the ridge sides vicinity, there are the p-GaAs contact layer 109 and the resist mask 110, the permeation of the etchant becomes significant, and the etching is faster than the other flat portions.

For this reason, in the ridge vicinity, the p-AlInP second p-type clad layer 107 is removed to expose the GaInP etching stop layer 106. On the contrary, the p-AlInP second p-type clad layer 107 remains on the region away from the ridge. However, the current confinement action and the light confinement are carried out only in the ridge vicinity region. Thus, even if the p-AlInP second p-type clad layer 107 remains on the region away from the ridge, there is no case that a problem is induced in the laser property.

Also, in the etching, after the elapse of about two minutes from the etching start, the resist mask 110 begins to be eroded by the etchant. However, since instead of the resist mask 110, the p-GaAs contact layer 109 that is not eroded by the etchant acts the role of the mask, there is no problem on the etching control.

Next, similarly to the semiconductor laser device 600 in the sixth embodiment, the stripe-shaped resist mask 110 is removed to expose the p-GaAs contact layer 109 (refer to Fig. 8A).

Next, as shown in Fig. 10A, the insulating film 702 is formed on the entire surface of the ridge top surface, the ridge sides and the GaInP etching stop layer 106 of the ridge flanks.

Next, as shown in Fig. 10B, the insulating film 702 of the ridge top surface, the ridge sides and the ridge bottom end vicinity is etched and removed, thereby exposing the p-GaAs contact layer 109 of the ridge top surface and the GaInP etching stop layer 106 of the ridge sides and the ridge bottom end vicinity.

In succession, as shown in Fig. 10C, the Ti/Pt/Au multilayer film is evaporated on the p-GaAs contact layer 109 of the ridge top surface, on the GaInP etching stop layer 106 which is exposed on the ridge sides and the ridge bottom end vicinity, and on the entire surface of the insulating film 702 of the ridge flanks, and the p-side electrode 704 is formed.

After the rear of the n-GaAs substrate 101 is polished and adjusted to the predetermined substrate thickness, an n-side electrode 112 is formed on the substrate rear. Consequently, it is possible to obtain the semiconductor wafer for the laser having the structure shown in Fig. 9.

Next, by cleaving the semiconductor wafer for the laser in the ridge stripe direction and the vertical direction, it is possible to manufacture the semiconductor laser device 700 having a pair of resonator reflection surfaces.

This embodiment uses the etchant composed of acetic acid : hydrogen peroxide : hydrochloric acid, and carries out the wet etching, and forms the ridge. Thus, the action of the above-mentioned etching mechanism makes the control of the ridge shape easier.

Also, since this embodiment does not require the second epitaxial growing step, the process is simple.

By the way, in the semiconductor laser device 600 in this embodiment, the respective compound semiconductor layers are epitaxially grown by using the metal-organic vapor phased growing method, such as the MOVEP method, the MOCVD method or the like. However, it is not limited thereto. The film may be formed, for example, by using the MBE (Molecular Beam Epitaxy) method or the like.

Also, this embodiment is designed such that the layer thickness of the p-AlInP first p-type clad layer 105 is 0.40 µm, the layer thickness of the GaInP etching stop layer 106 is 15 nm, and the layer thickness of the p-AlInP second p-type clad layer 107 is 1.6 µm. However, in designing the lateral radiation angle property and the like, any layer structure may be designed.

By the way, if the clad layer structure different from this embodiment is employed in designing the lateral radiation angle property and the like, on the process, it is obviously allowable to change the concentration of acetic acid : hydrogen peroxide : hydrochloric acid and the etching period so as to make the etching control easier.

Also, in this embodiment, when the GaInP etching stop layer 106 is exposed, the etching is stopped. Then, on the top surface thereof, the p-side electrode 111 is evaporated on the entire surface of the ridge top surface, the ridge sides and the GaInP etching stop layer 106 of the ridge flanks. However, it may be configured such that after the p-AlInP second lad layer 107 is etched, the GaInP etching stop layer 106 is further removed and the p-AlInP first clad layer 105 is exposed and the insulating film 602 is formed thereon.

### INDUSTRIAL APPLICABILITY

The first to third embodiments can be also applied to a semiconductor laser array or a semiconductor laser stack in which the semiconductor laser devices are arrayed in array manner or stack manner.

## Claims

1. A semiconductor laser device comprising:
a laminated structure sequentially having at least a first conductive type AlInP clad layer (103), an AlGaInP-based superlattice active layer section (104) and a first second conductive type AlInP clad layer (105), on a first conductive type semiconductor substrate (101);
wherein the superlattice active layer section is constituted as an SCH (Separated Confinement Heterostructure) structure composed of at least one quantum well layer, which is sandwiched between a barrier layer and an optical guide layer, and the composition of the quantum well layer is AlₓGa₁₋ₓInP (0<=1x<1), and the composition of the barrier layer is AlyGa_{1-y}InP (0<y<=1), where (x<y);
a current confinement structure configured by forming an upper portion made of a second second conductive type AlInP clad layer (107) and a second conductive type compound semiconductor layer in the laminated structure into a stripe-shaped ridge;
wherein an electrode (111) on a second conductive side made of metal film extends on a ridge top surface, ridge sides and the first second conductive type AlInP clad layer (105) of ridge flanks, and covers the ridge top surface, the ridge sides and the first second conductive type AlInP clad layer (105) of the ridge flanks; and
a carrier concentration of the second conductive type compound semiconductor layer of the ridge top surface is higher than a carrier concentration of the second second conductive type AlInP clad layer (107).

2. The semiconductor laser device according to claim 1, **characterized in that**:
the electrode (111) directly covers the ridge top surface, the ridge sides and the first second conductive type AlInP clad layer (105) of the ridge flanks.

3. The semiconductor laser device according to claim 1,
**characterized in that**:
an AlGaInP-based compound semiconductor layer functioning as an etching stop layer extends on the first second conductive type AlInP clad layer of the ridge flanks, and
the second conductive side electrode made of the metal film extends on the ridge top surface, the ridge sides and the AlGaInP-based compound semiconductor layer, and directly covers the ridge top surface, the ridge sides and the AlGaInP-based compound semiconductor layer.

4. A semiconductor laser device according to claim 1 **characterized in that**:
an insulating film (602) extends on ridge sides and the first second conductive type AlInP clad layer (105) of ridge flanks, so as to expose a ridge top surface in stripe-shaped manner, and that
the second conductive side electrode made of metal film extends on the ridge top surface exposed from the insulating film, and further on the ridge sides and the first second conductive type AlInP clad layer of the ridge flanks through the insulating film.

5. The semiconductor laser device according to claim 4, **characterized in that**:
an AlGaInP-based compound semiconductor layer functioning as an etching stop layer extends on the first second conductive type AlInP clad layer of the ridge flanks; and that
the insulating film extends on the ridge sides and the AlGaInP-based compound semiconductor layer of the ridge flanks, so as to expose the ridge top surface; and
the second conductive side electrode made of the metal film extends on the ridge top surface exposed from the insulating film, and further on the ridge sides and the AlGaInP-based compound semiconductor layer of the ridge flanks through the insulating film.

6. A semiconductor laser device according to claim 1 **characterized in that**:
an insulating film extends on the first second conductive type AlInP clad layer of ridge flanks, so as to expose a ridge top surface, ridge sides and the second conductive type AlInP clad layer of ridge bottom end vicinity in stripe-shaped manner, and that
the second conductive side electrode made of metal film extends on the ridge top surface, the ridge sides and the first second conductive type AlInP clad layer of the ridge bottom end vicinity, which are exposed from the insulating film, and further extends on the first second conductive type AlInP clad layer of the ridge flanks through the insulating film.

7. The semiconductor laser device according to claim 6, **characterized in that**:
an AlGaInP-based compound semiconductor layer functioning as an etching stop layer extends on the first second conductive type AlInP clad layer of the ridge flanks;
the insulating film extends on the AlGaInP-based compound semiconductor layer of the ridge flanks, so as to expose the ridge top surface, the ridge sides and the AlGaInP-based compound semiconductor layer of ridge bottom end vicinity; and
the second conductive side electrode made of the metal film extends on the ridge top surface, the ridge sides and the AlGaInP-based compound semiconductor layer of the ridge bottom end vicinity, which are exposed from the insulating film, and further extends on the AlGaInP-based compound semiconductor layer of the ridge flanks through the insulating film.

8. The semiconductor laser device according to any one of claims 1 to 7,
**characterized in that** the first conductive type is an n-type, the second conductive type is a p-type, and the second conductive side electrode is a p-side electrode.

9. The semiconductor laser device according to any one of claims 1 to 8, **characterized in that** a stripe width of the ridge is 10 µm or more.

10. The semiconductor laser device according to any one of claims 1 to 9, **characterized in that** the laminated structure is a laminated structure configured by laminating: a buffer layer composed of at least one layer of an n-GaAs layer or an n-GaInP layer; an n-type clad layer made of n-AlInP; an AlGaInP-based superlattice active layer section; a first p-type clad layer made of p-AlInP; an etching stop layer made of GaInP; a second p-type clad layer made of p-AlInP; a protective layer made of GaInP; and a contact layer made of p-GaAs, sequentially on an n-GaAs substrate; and
in the laminated structure, the p-AlInP second p-type clad layer and the p-GaAs contact layer are processed into the stripe-shaped ridge, thereby configuring the current confinement structure.

11. The semiconductor laser device according to claim 1, **characterized in that** the superlattice active layer section is configured as a multiple quantum well structure composed of the quantum well layer of plural layers, which are sandwiched between the barrier layer and the optical guide layer.

12. A manufacturing method of a semiconductor laser device, comprising:
a step of sequentially epitaxial growth a buffer layer (102) composed of at least one of an n-GaAs layer or an n-GaInP layer, an n-type clad layer (103) made of n-AlInP, a superlattice active layer section (104), a first p-type clad layer (105) made of p-AlInP, an etching stop layer (106) made of GaInP, a second p-type clad layer (107) made of p-AlInP, a protective layer (108) made of GaInP, and a contact layer (109) made of p-GaAs, on an n-GaAs substrate (101);
a step of etching processing the p-GaAs contact layer (109) into stripe-shaped manner;
a step of processing into stripe-shaped ridge by etching the GaInP protective layer and the p-AlInP second p-type clad layer using the stripe-shaped p-GaAs contact layer as an etching mask, and exposing the GaInP etching stop layer on ridge flanks; and
a step of forming a metal film constituting a p-side electrode on the p-GaAs contact layer of a ridge top surface, ridge sides and the GaInP etching stop layer of the ridge flanks.

13. The manufacturing method of the semiconductor laser device according to claim 12, **characterized in that** the step of etching the GaInP protective layer and the p-AlInP second p-type clad layer uses a wet etching method, which uses acetic acid : hydrogen peroxide : hydrochloric acid, to then etch.

14. The manufacturing method of the semiconductor laser device according to claim 12 or 13, **characterized in that** the p-type compound semiconductor layer is replaced by an n-type compound semiconductor layer, and the n-type compound semiconductor layer is replaced by a p-type compound semiconductor layer, namely, they are replaced by the opposite conductive types, respectively.

15. A manufacturing method of a semiconductor laser device according to claim 12 in that it further comprises:
a step of forming an insulating film (602) on an entire surface of the ridge top surface, the ridge sides and the GaInP etching stop layer (106);
a step of etching the insulating film and exposing a ridge top surface in stripe-shaped manner; and that
the metal film constituting the p-side electrode is formed on the p-GaAs contact layer of the ridge top surface and on the ridge sides and the GaInP etching stop layer of the ridge flanks through the insulating film.

16. The manufacturing method of the semiconductor laser device according to claim 15, **characterized in that**:
the step of etching the insulating film and exposing the ridge top surface further exposes the ridge sides and the GaInP etching stop layer of ridge bottom end vicinity; and
the step of forming the p-side electrode forms the metal film constituting the p-side electrode on the p-GaAs contact layer of the exposed ridge top surface, the ridge sides and the GaInP etching stop layer of the ridge bottom end vicinity, and further forming on the GaInP etching stop layer of the ridge flanks through the insulating film.

17. The manufacturing method of the semiconductor laser device according to claim 15 or 16, **characterized in that** the step of etching the GaInP protective layer and the p-AlInP second p-type clad layer uses a wet etching method, which uses acetic acid : hydrogen peroxide : hydrochloric acid, to then etch.

18. The manufacturing method of the semiconductor laser device according to claim 17, **characterized in that** the p-type compound semiconductor layer is replaced by an n-type compound semiconductor layer, and the n-type compound semiconductor layer is replaced by a p-type compound semiconductor layer, namely, they are replaced by the opposite conductive types, respectively.

## Patentansprüche

1. Halbleiterlasereinrichtung, welche umfasst:
eine Schichtstruktur, welche sequentiell zumindest eine erste leitfähige AlInP-Verbundschicht (103), einen aktiven Überzugsstruktur-Schichtabschnitt (104) auf AlGaInP-Basis, und eine erste leitfähige Zweit-AlInP-Verbundschicht (105) auf einem ersten leitfähigen Halbleitersubstrat (101) hat;
wobei der aktive Überzugsstruktur-Schichtabschnitt aus einer SCH-Struktur (getrennte Grenzheterostruktur) gebildet ist, welcher aus zumindest einer Quantumwannen-Schicht zusammengesetzt ist, welche zwischen einer Barrierenschicht und einer optischen Führungsschicht eingezwängt ist, und die Zusammensetzung der Quantum-Wannenschicht AlₓGa₁₋ₓInP (0≤1x<1) ist, und die Zusammensetzung der Barrierenschicht Al_{y}Ga_{1-y}InP (0<y<=1) ist, wobei (x<y); und
eine Strombeschränkungsstruktur, welche durch Bilden eines oberen Bereichs gebildet wird, der aus einer zweiten leitfähigen Zweit-AlInP-Verbundschicht (107) und einer zweiten leitfähigen Verbindungshalbleiterschicht in der geschichteten Struktur zu einer streifenförmigen Grat-bzw. Kammform hergestellt ist;
wobei eine Elektrode (111) auf einer zweiten leitfähigen Seite, welche aus Metallfilm hergestellt ist, sich auf einer Kammkopffläche, Kammseiten und der ersten leitfähigen Zweit-AlInP-Verbundschicht (105) aus Kammflanken erstreckt und die Kammkopffläche, die Kammseiten und die erste leitfähige Zweit-AlInP-Verbundschicht (105) der Kammflanken überdeckt; und
eine Trägerkonzentration der zweiten leitfähigen Verbindungshalbleiterschicht der Kammkopffläche höher ist als eine Trägerkonzentration der zweiten leitfähigen Zweit-AlInP-Verbundschicht (107).

2. Halbleiterlasereinrichtung nach Anspruch 1, **dadurch gekennzeichnet, dass**:
die Elektrode (111) unmittelbar die Kammkopffläche, die Kammseiten und die erste leitfähige Zweit-AlInP-Verbindungsschicht (105) der Kammflanken überdeckt.

3. Halbleiterlasereinrichtung nach Anspruch 1,
**dadurch gekennzeichnet, dass**:
eine Verbindungshalbleiterschicht auf Basis von AlGaInP, welche als eine Ätzstoppschicht arbeitet, sich auf der ersten leitfähigen Zweit-AlInP-Verbundschicht der Kammflanken erstreckt, und
die zweite leitfähige Seitenelektrode, welche aus dem Metallfilm hergestellt ist, sich auf der Kammkopffläche, den Kammseiten und der Verbindungshalbleiterschicht auf AlIGalnP-Basis erstreckt, und unmittelbar die Kammkopffläche, die Kammseiten und die AlGaInP-Verbindungshalbleiterschicht überdeckt.

4. Halbleiterlasereinrichtung nach Anspruch 1, **dadurch gekennzeichnet, dass**:
ein Isolationsfilm (602) sich auf Kammseiten und der ersten leitfähigen AlInP-Verbundschicht (105) der Kammflanken erstreckt, um somit eine Kammkopffläche in streifenförmiger Weise freizugeben, und dass
die zweite leitfähige Seitenelektrode, welche aus Metallfilm hergestellt ist, sich auf der Kammkopffläche erstreckt, welche vom Isolationsfilm freigelegt ist, und weiter auf den Kammseiten und der ersten leitfähigen Zweit-AlInP-Verbundschicht der Kammflanken durch den Isolationsfilm hindurch.

5. Halbleiterlasereinrichtung nach Anspruch 4, **dadurch gekennzeichnet, dass**:
eine Verbindungsleiterschicht auf Basis von AlGaInP, welche als eine Ätzstoppschicht arbeitet, sich auf der ersten leitfähigen Zweit-AlInP-Verbundschicht der Kammflanken erstreckt; und dass
der Isolationsfilm sich auf den Kammseiten und der AlGaInP-Verbindungshalbleiterschicht der Kammflanken erstreckt, um somit die Kammkopffläche freizulegen; und
die zweite leitfähige Seitenelektrode, welche aus dem aus Metallfilm hergestellt ist, sich auf der Kammkopffläche erstreckt, welche vom Isolationsfilm freigelegt ist, und weiter auf den Kammseiten und der AlGaInP-Verbundhalbleiterschicht der Kammflanken durch den Isolationsfilm hindurch.

6. Halbleiterlasereinrichtung nach Anspruch 1, **dadurch gekennzeichnet, dass**:
ein Isolationsfilm sich auf der ersten leitfähigen Zweit-AlInP-Verbundschicht der Kammflanken erstreckt, um somit eine Kammkopffläche, Kammseiten und die zweite leitfähige AlInP-Verbundschicht der Kammboden-Endnachbarschaft in streifenförmiger Weise freizulegen, und dass
die zweite leitfähige Seitenelektrode, welche aus dem Metallfilm hergestellt ist, sich auf der Kammkopffläche, den Kammseiten und der ersten leitfähigen Zweit-AlInP-Verbundschicht der Kammboden-Endnachbarschaft erstreckt, welche von dem Isolationsfilm freigelegt sind, und sich außerdem auf der ersten leitfähigen Zweit-AlInP-Verbundschicht der Kammflanken durch den Isolationsfilm hindurch erstreckt.

7. Halbleiterlasereinrichtung nach Anspruch 6, **dadurch gekennzeichnet, dass**:
eine Verbindungshalbleiterschicht auf Basis von AlGaInP, welche als eine Ätzstoppschicht arbeitet, sich auf der ersten leitfähigen Zweit-AlInP-Verbundschicht der Kammflanken erstreckt;
der Isolationsfilm sich auf der AlGaInP-Verbindungshalbleiterschicht der Kammflanken erstreckt, um somit die Kammkopffläche, die Kammseiten und die AlGaInP-Verbundhalbleiterschicht der Kammboden-Endnachbarschaft freizulegen; und
die zweite leitfähige Seitenelektrode, welche aus dem Metallfilm hergestellt ist, sich auf der Kammkopffläche, den Kammseiten und der AlGaInP-Verbundhalbleiterschicht der Kammboden-Endnachbarschaft erstreckt, welche vom Isolationsfilm freigelegt sind, und sich außerdem auf der AlGaInP-Verbindungshalbleiterschicht der Kammflanken durch den Isolationsfilm hindurch erstreckt.

8. Halbleiterlasereinrichtung nach einem der Ansprüche 1 bis 7, **dadurch gekennzeichnet, dass** der erste Leitfähigkeitstypus ein n-Typus, der zweite Leitfähigkeitstypus ein p-Typus und die zweite leitfähige Seitenelektrode eine p-Seitenelektrode ist.

9. Halbleiterlasereinrichtung nach einem der Ansprüche 1 bis 8, **dadurch gekennzeichnet, dass** eine Streifenbreite des Kamms 10 µm oder mehr beträgt.

10. Halbleiterlasereinrichtung nach einem der Ansprüche 1 bis 9, **dadurch gekennzeichnet, dass** die Schichtstruktur eine Schichtstruktur ist, welche durch Schichtbildung sequentiell auf einem n-GaAs-Substrat aufgebaut ist: eine Pufferschicht, welche zumindest aus einer Schicht aus einer n-GaAs-Schicht oder einer nGalnP-Schicht zusammengesetzt ist; eine n-Verbundschicht, welche aus n-AlInP hergestellt ist; eine aktive Überzugsstrukturschichtabschnitt auf Basis von AlGaInP; eine erste p-Verbundschicht, welche aus p-AlInP hergestellt ist; eine Ätzstoppschicht, welche aus GaInP hergestellt ist; eine zweite p-Verbundschicht, welche aus p-AlInP hergestellt ist; eine Schutzschicht, welche aus GaInP hergestellt ist; und eine Kontaktschicht, welche aus p-GaAs hergestellt ist; und
in der Schichtstruktur die zweite p-AlInP-p-Verbundschicht und die p-GaAs-Kontaktschicht zu dem streifenförmigen Kamm bearbeitet werden, um **dadurch** die Strombegrenzungsstruktur aufzubauen.

11. Halbleiterlasereinrichtung nach Anspruch 1, **dadurch gekennzeichnet, dass** der aktive Überzugsschichtabschnitt als eine Mehrfachquantum-Wannenstruktur aufgebaut ist, welche aus der Quantumwannenstruktur mehrerer Schichten zusammengesetzt ist, welche zwischen der Barrierenschicht und der optischen Führungsschicht eingezwängt sind.

12. Herstellungsverfahren einer Halbleiterlasereinrichtung, welches umfasst:
einen Schritt sequentiellen epitaxialen Wachstums einer Pufferschicht (102), welche zumindest aus einem von einer n-GaAs-Schicht oder einer n-GaInP-Schicht zusammengesetzt ist, einer n-Verbundschicht (103), welche aus AlInP hergestellt ist, einer aktiven Überzugsschichtabschnitt (104), einer ersten p-Verbundschicht (105), welche aus p-AlInP hergestellt ist, einer Ätzstoppschicht (106), welche aus GaInP hergestellt ist, einer zweiten p-Verbundschicht (107), welche aus p-AlInP hergestellt ist, einer Schutzschicht (108), welche aus GaInP hergestellt ist, und einer Kontaktschicht (109), welche aus p-GaAs hergestellt ist, auf einem n-GaAs-Substrat (101);
einen Schritt zur Ätzbearbeitung der p-GaAs-Kontaktschicht (109) zu streifenförmiger Art;
einen Schritt zum Bearbeiten zu streifenförmigem Kamm durch Ätzen der GaInP-Schutzschicht und der zweiten p-AlInP-p-Verbundschicht unter Verwendung der streifenförmigen p-GaAs-Kontaktschicht als eine Ätzmaske, und Freilegen der GaInP-Ätzstoppschicht auf Kammflanken; und
einen Schritt zum Bilden eines Metallfilms, der eine p-seitige Elektrode auf der p-GaAs-Kontaktschicht einer Kammkopffläche, Kammseiten und der GaInP-Ätzstoppschicht der Kammflanken bildet.

13. Herstellungsverfahren der Halbleiterlasereinrichtung nach Anspruch 12, **dadurch gekennzeichnet, dass** der Schritt zum Ätzen der GaInP-Schutzschicht und der zweiten p-AlInP-p-Verbundschicht ein Nassätzverfahren verwendet, welches Essigsäure: Wasserstoffperoxid: Salzsäure verwendet, um dann zu ätzen.

14. Herstellungsverfahren der Halbleiterlasereinrichtung nach Anspruch 12 oder 13, **dadurch gekennzeichnet, dass** die p-Verbindungshalbleiterschicht durch eine n-Verbindungshalbleiterschicht ersetzt wird, und die n-Verbindungshalbleiterschicht durch eine p-Verbindungshalbleiterschicht ersetzt wird, nämlich, dass sie durch die entgegengesetzten Leitfähigkeitsarten ersetzt werden.

15. Herstellungsverfahren einer Halbleiterlasereinrichtung nach Anspruch 12, dass dies außerdem umfasst:
einen Schritt zum Bilden eines Isolationsfilms (602) auf einer gesamten Fläche der Kammkopffläche, den Kammseiten und der GaInP-Ätzstoppschicht (106);
einen Schritt zum Ätzen des Isolationsfilms und zum Freilegen einer Kammkopffläche in streifenförmiger Weise; und dass
der Metallfilm, der die p-seitige Elektrode bildet, auf der p-GaAs-Kontaktschicht der Kammkopffläche und auf den Kammseiten und der GaInP-Ätzstoppschicht der Kammflanken durch den Isolationsfilm hindurch gebildet ist.

16. Herstellungsverfahren der Halbleiterlasereinrichtung nach Anspruch 15, **dadurch gekennzeichnet, dass**:
der Schritt zum Ätzen des Isolationsfilms und zum Freilegen der Kammkopffläche außerdem die Kammseiten und die GaInP-Ätzstoppschicht der Kammboden-Endnachbarschaft freilegt; und
der Schritt zum Bilden der p-seitigen Elektrode den Metallfilm, der die p-seitige Elektrode bildet, auf der p-GaAs-Kontaktschicht der freigelegten Kammkopffläche, den Kammseiten und der GaInP-Ätzstoppschicht der Kammboden-Endnachbarschaft bildet, und außerdem das Bilden auf der GaInP-Ätzstoppschicht der Kammflanken durch den Isolationsfilm hindurch.

17. Herstellungsverfahren der Halbleiterlasereinrichtung nach Anspruch 15 oder 16, **dadurch gekennzeichnet, dass** der Schritt zum Ätzen der GaInP-Schutzschicht und der zweiten p-AlInP-p-Verbundschicht ein Nassätzverfahren verwendet, welches Essigsäure: Wasserstoffperoxid: Salzsäure verwendet, um dann zu ätzen.

18. Herstellungsverfahren der Halbleiterlasereinrichtung nach Anspruch 17, **dadurch gekennzeichnet, dass** die p-Verbundhalbleiterschicht durch eine n-Verbundhalbleiterschicht ersetzt wird, und die n-Verbundhalbleiterschicht durch eine p-Verbundhalbleiterschicht ersetzt wird, nämlich, dass sie jeweils durch die entsprechenden entgegengesetzten Leitfähigkeitsarten ersetzt werden.

## Revendications

1. Dispositif laser à semi-conducteur comprenant :
une structure stratifiée comportant séquentiellement au moins une couche de revêtement d'AlInP de premier type conducteur (103), une section couche active super-réseau à base d'AlGaInP (104) et une première couche de revêtement d'AlInP de second type conducteur (105), sur un substrat à semi-conducteur de premier type conducteur (101) ;
dans lequel la section couche active super-réseau est constituée comme structure SCH (hétérostructure à confinement séparé) composée d'au moins une couche à puits quantiques, qui est coincée entre une couche barrière et une couche de guidage optique, et la composition de la couche à puits quantiques est AlₓGa₁₋ₓInP (0<=1x<1), et la composition de la couche barrière est Al_{y}Ga_{1-y}InP (0<y<=1), où (x<y) ;
une structure à confinement de courant conçue en formant une partie supérieure composée d'une seconde couche de revêtement d'AlInP de second type conducteur (107) et d'une couche semi-conductrice composée de second type conducteur dans la structure stratifiée en une arête en forme de bande ;
dans lequel une électrode (111) située sur un second côté conducteur se composant d'un film métallique s'étend sur une surface supérieure d'arête, des côtés d'arête et la première couche de revêtement d'AlInP de second type conducteur (105) de flancs d'arête, et recouvre la surface supérieure d'arête, les côtés d'arête et la première couche de revêtement d'AlInP de second type conducteur (105) des flancs d'arête ; et
une concentration de porteurs de la couche semi-conductrice composée de second type conducteur de la surface supérieure d'arête est supérieure à une concentration de porteurs de la seconde couche de revêtement d'AlInP de second type conducteur (107).

2. Dispositif laser à semi-conducteur selon la revendication 1, **caractérisé en ce que** :
l'électrode (111) recouvre directement la surface supérieure d'arête, les côtés d'arête et la première couche de revêtement d'AlInP de second type conducteur des flancs d'arête.

3. Dispositif laser à semi-conducteur selon la revendication 1,
**caractérisé en ce que** :
une couche semi-conductrice composée à base d'AlgaInP servant de couche d'arrêt de gravure s'étend sur la première couche de revêtement d'AlInP de second type conducteur des flancs d'arête, et
l'électrode de second côté conducteur composée du film métallique s'étend sur la surface supérieure d'arête, les côtés d'arête et la couche semi-conductrice composée à base d'AlGaInP, et recouvre directement la surface supérieure d'arête, les côtés d'arête et la couche semi-conductrice composée à base d'AlGaInP.

4. Dispositif laser à semi-conducteur selon la revendication 1, **caractérisé en ce que** :
un film isolant (602) s'étend sur les côtés d'arête et la première couche de revêtement d'AlInP de second type conducteur (105) de flancs d'arête, de manière à exposer une surface supérieure d'arête d'une manière en forme de bande, et **en ce que**
l'électrode de second côté conducteur composé d'un film métallique s'étend sur la surface supérieure d'arête exposée à partir du film isolant, et en outre sur les côtés d'arête et la première couche de revêtement d'AlInP de second type conducteur des flancs d'arête à travers le film isolant.

5. Dispositif laser à semi-conducteur selon la revendication 4, **caractérisé en ce que** :
une couche semi-conductrice composée à base d'AlGaInP servant de couche d'arrêt de gravure s'étend sur la première couche de revêtement d'AlInP de second type conducteur des flancs d'arête ; et **en ce que**
le film isolant s'étend sur les côtés d'arête et la couche semi-conductrice composée à base d'AlgaInP des flancs d'arête, de manière à exposer la surface supérieure d'arête ; et
l'électrode de second côté conducteur composée du film métallique s'étend sur la surface supérieure d'arête exposée à partir du film isolant, et en outre sur les côtés d'arête et la couche semi-conductrice composée à base d'AlGaInP des flancs d'arête à travers le film isolant.

6. Dispositif laser à semi-conducteur selon la revendication 1, **caractérisé en ce que** :
un film isolant s'étend sur la première couche de revêtement d'AlInP de second type conducteur de flancs d'arête, de manière à exposer une surface supérieure d'arête, des côtés d'arête et la couche de revêtement d'AlInP de second type conducteur des environs de l'extrémité inférieure d'arête d'une manière en forme de bande, et **en ce que**
l'électrode de second côté conducteur composée d'un film métallique s'étend sur la surface supérieure d'arête, les côtés d'arête et la première couche de revêtement d'AlInP de second type conducteur des environs de l'extrémité inférieure d'arête, qui sont exposés à partir du film isolant, et s'étend en outre sur la première couche de revêtement d'AlInP de second type conducteur des flancs d'arête à travers le film isolant.

7. Dispositif laser à semi-conducteur selon la revendication 6, **caractérisé en ce que** :
une couche semi-conductrice composée à base d'AlGaInP servant de couche d'arrêt de gravure s'étend sur la première couche de revêtement d'AlInP de second type conducteur des flancs d'arête ;
le film isolant s'étend sur la couche semi-conductrice composée à base d'AlGaInP des flancs d'arête, de manière à exposer la surface supérieure d'arête, les côtés d'arête et la couche semi-conductrice composée à base d'AlGaInP des environs de l'extrémité inférieure d'arête ; et **en ce que**
l'électrode de second côté conducteur composée du film métallique s'étend sur la surface supérieure d'arête, les côtés d'arête et la couche semi-conductrice composée à base d'AlGaInP des environs de l'extrémité inférieure d'arête, qui sont exposés à partir du film isolant, et s'étend en outre sur la couche semi-conductrice composée à base d'AlGaInP des flancs d'arête à travers le film isolant.

8. Dispositif laser à semi-conducteur selon l'une quelconque des revendications 1 à 7,
**caractérisé en ce que** le premier type conducteur est un type n, le second type conducteur est un type p, et l'électrode de second côté conducteur est une électrode de côté p.

9. Dispositif laser à semi-conducteur selon l'une quelconque des revendications 1 à 8, **caractérisé en ce qu'**une largeur de bande de l'arête est de 10 µm ou plus.

10. Dispositif laser à semi-conducteur selon l'une quelconque des revendications 1 à 9, **caractérisé en ce que** la structure stratifiée est une structure stratifiée conçue en stratifiant : une couche tampon composée d'au moins une couche de GaAs-n ou d'une couche de GaInP-n ; une couche de revêtement de type n composée d'AlInP-n ; une section couche active super-réseau à base d'AlGaInP; une première couche de revêtement de type p composée d'AlInP-p ; une couche d'arrêt de gravure composée de GaInP ; une seconde couche de revêtement de type p composée d'AlInP-p ; une couche de protection composée de GaInP ; et une couche de contact composée de GaAs-p, séquentiellement sur un substrat de GaAs-n ; et
dans la structure stratifiée, la seconde couche de revêtement de type p d'AlInP-p et la couche de contact en GaAs-p sont traitées dans l'arête en forme de bande, concevant ainsi la structure à confinement de courant.

11. Dispositif laser à semi-conducteur selon la revendication 1, **caractérisé en ce que** la section couche active super-réseau est conçue comme structure à puits quantiques multiples composée de la couche à puits quantiques de plusieurs couches, qui sont coincées entre la couche barrière et la couche de guidage optique.

12. Procédé de fabrication d'un dispositif laser à semi-conducteur comprenant :
une étape de croissance épitaxiale séquentielle d'une couche tampon (102) composée d'au moins une couche de GaAs-n et/ou une couche de GaInP-n, d'une couche de revêtement de type n (103) composée d'AlInP-n, d'une section couche active super-réseau (104), d'une première couche de revêtement de type p (105) composée d'AlInp-p, d'une couche d'arrêt de gravure (106) composée de GaInP, d'une seconde couche de revêtement de type p (107) composée d'AlInP-p, d'une couche de protection (108) composée de GaInP, et d'une couche de contact (109) composée de GaAs-p, sur un substrat de GaAs-n (101) ; et
une étape de gravure de manière à traiter la couche de contact de GaAs-p (109) en forme de bande ;
une étape de traitement en arête en forme de bande en gravant la couche de protection de GaInP et la seconde couche de revêtement de type p d'AlInP-p à l'aide de la couche de contact de GaAs-p en forme de bande comme masque de gravure, et en exposant la couche d'arrêt de gravure de GaInP sur les flancs d'arête ; et
une étape de formation d'un film métallique constituant une électrode de côté p sur la couche de contact de GaAs-p d'une surface supérieure d'arête, les côtés d'arête et la couche d'arrêt de gravure de GaInP des flancs d'arête.

13. Procédé de fabrication du dispositif laser à semi-conducteur selon la revendication 12, **caractérisé en ce que** l'étape de gravure de la couche de protection de GaInP et de la seconde couche de revêtement de type p d'AlInP-p utilise un procédé de gravure humide, qui utilise de l'acide acétique : peroxyde d'hydrogène : acide chlorhydrique, afin de graver.

14. Procédé de fabrication du dispositif laser à semi-conducteur selon la revendication 12 ou 13, **caractérisé en ce que** la couche semi-conductrice composée de type p est remplacée par une couche semi-conductrice composée de type n, et la couche semi-conductrice composée de type n est remplacée par une couche semi-conductrice composée de type p, à savoir, elles sont respectivement remplacées par les types conducteurs opposés.

15. Procédé de fabrication d'un dispositif laser à semi-conducteur selon la revendication 12, **caractérisé en ce qu'**il comprend en outre :
une étape de formation d'un film isolant (602) sur toute une surface de la surface supérieure d'arête, les côtés d'arête et la couche d'arrêt de gravure de GaInP (106) ;
une étape de gravure du film isolant et d'exposition d'une surface supérieure d'arête d'une manière en forme de bande ; et **en ce que**
le film métallique constituant l'électrode de côté p est formée sur la couche de contact de GaAs-p de la surface supérieure d'arête et sur les côtés d'arête et la couche d'arrêt de gravure de GaInP des flancs d'arête à travers le film isolant.

16. Procédé de fabrication du dispositif laser à semi-conducteur selon la revendication 15, **caractérisé en ce que** :
l'étape de gravure du film isolant et d'exposition de la surface supérieure d'arête expose en outre les côtés d'arête et la couche d'arrêt de gravure de GaInP des environs de l'extrémité inférieure d'arête ; et
l'étape de formation de l'électrode de côté p forme le film métallique constituant l'électrode de côté p sur la couche de contact de GaAs-p de la surface supérieure d'arête exposée, les côtés d'arête et la couche d'arrêt de gravure de GaInP des environs de l'extrémité inférieure d'arête, et se formant en outre sur la couche d'arrêt de gravure de GaInP des flancs d'arête à travers le film isolant.

17. Procédé de fabrication du dispositif laser à semi-conducteur selon la revendication 15 ou 16, **caractérisé en ce que** l'étape de gravure de la couche de protection de GaInP et de la seconde couche de revêtement de type p d'AlInP-p utilise un procédé de gravure humide, qui utilise de l'acide acétique : peroxyde d'hydrogène : acide chlorhydrique, afin de graver.

18. Procédé de fabrication du dispositif laser à semi-conducteur selon la revendication 17, **caractérisé en ce que** la couche semi-conductrice composée de type p est remplacée par une couche semi-conductrice composée de type n, et la couche semi-conductrice composée de type n est remplacée par une couche semi-conductrice composée de type p, à savoir, elles sont respectivement remplacées par les types conducteurs opposés.
